# EUROPEAN PATENT SPECIFICATION

(11) **EP 4 485 688 B1**
(45) Date of publication and mention of the grant of the patent: **14.10.2026**
(21) Application number: 23775326.4
(22) Date of filing: 23.03.2023
(51) Int. Cl.: H01Q 1/24, H01Q 1/38, H01Q 1/46, H01Q 1/48, H05K 1/02, H04M 1/02, H01Q 13/10, H05K 1/189

(54) **ELECTRONIC DEVICE COMPRISING ANTENNA STRUCTURE**
ELEKTRONISCHE VORRICHTUNG MIT ANTENNENSTRUKTUR
DISPOSITIF ÉLECTRONIQUE COMPRENANT UNE STRUCTURE D'ANTENNE

(30) Priority: 24.03.2022 KR 20220036952; 14.04.2022 KR 20220046571
(43) Date of publication of application: 01.01.2025
(73) Proprietor: Samsung Electronics Co., Ltd., Suwon-si, Gyeonggi-do 16677 (KR)
(72) Inventor: LEE, Minkyung, Suwon-si Gyeonggi-do 16677 (KR); KANG, Woosuk, Suwon-si Gyeonggi-do 16677 (KR); KIM, Yunsik, Suwon-si Gyeonggi-do 16677 (KR); SEO, Mincheol, Suwon-si Gyeonggi-do 16677 (KR); SEOL, Kyungmoon, Suwon-si Gyeonggi-do 16677 (KR); SHIN, Donghun, Suwon-si Gyeonggi-do 16677 (KR); YU, Changha, Suwon-si Gyeonggi-do 16677 (KR); PARK, Gyubok, Suwon-si Gyeonggi-do 16677 (KR)
(74) Representative: HGF
(86) International application number: PCT/KR2023/003867
(87) International publication number: WO 2023/182831

(56) References cited:
- KR-A- 20120 004 338
- KR-A- 20140 139 520
- KR-A- 20190 123 122
- KR-A- 20200 131 159
- KR-A- 20210 158 205
- US-A1- 2013 162 485
- US-A1- 2020 153 115
- US-A1- 2021 135 492

## Description

### [Technical Field]

Various embodiments of the present invention relate to an electronic device including an antenna structure.

### [Background Art]

An electronic device having a deformable form factor is being developed, using a flexible display. The electronic device may provide, using a flexible display slidable into a housing, a user experience based on a shape of the flexible display and/or the electronic device to a user. For example, the electronic device may change content displayed on the flexible display, based on a shape of the flexible display insertable into or extractable from the housing.

US 2020153115A1 discloses that an electronic device may include a housing including a first plate facing a first direction, a second plate facing a second direction opposite the first direction, and a side housing surrounding a space between the first plate and the second plate, wherein the side housing includes a first portion, including an external metal portion having a first face facing an outside and a second face facing the space and an internal polymer portion having a third face contacting the second face and a fourth face facing the space, a touch screen display positioned within the space to be viewable through the first plate, wherein an edge of the touch screen display is spaced apart from the first portion of the side housing and when the first plate is viewed from above, the gap is covered by a peripheral portion of the first glass plate, an antenna structure comprising at least one antenna and configured to include a substrate having a fifth face substantially parallel to the second face and a sixth face facing a direction opposite the fifth face and at least one conductive pattern positioned between the fifth face and the sixth face and extending toward the peripheral portion of the first plate, and wireless communication circuitry operatively connected to the at least one conductive pattern and configured to form a directivity beam using at least a part of the at least one conductive pattern.

US 2021135492A1 discloses that an electronic device may comprise: a first structure comprising a first plate including a first surface and a second surface facing away from the first surface; a second structure comprising a second plate facing the second surface of the first plate, a first sidewall perpendicular to the second plate, a second sidewall perpendicular to the first sidewall and the second plate, and a third sidewall perpendicular to the first sidewall and the second plate and parallel to the second sidewall, wherein the first sidewall includes a conductive portion, and the second plate, the first sidewall, the second sidewall, and the third sidewall together form a trough with one side open to receive at least a portion of the first structure, and the first structure is movable between an open state and a closed state with respect to the second structure in a first direction parallel to the second plate and the second sidewall such that the first structure is located at a first distance from the first sidewall in the closed state and is located at a second distance greater than the first distance from the first sidewall in the open state; a flexible touch screen display layer comprising: a planar portion extending across at least a portion of the first surface and mounted to the first surface; and a bendable portion extending, during the closed state, from the planar portion into a space between the first sidewall and the first structure, wherein when the first structure is moved from the closed state to the open state, at least a portion of the bendable portion forms a substantially planar surface between the planar portion and the first sidewall as viewed from the top of the first plate; a conductive pattern mounted on the second plate between the second surface and the second plate; a first conductive path extending between the conductive portion of the first sidewall and the conductive pattern; a printed circuit board mounted on the first structure; a wireless charging circuit mounted on the printed circuit board; a wireless communication circuit mounted on the printed circuit board; and a flexible conductive path connected between the printed circuit board and the conductive pattern, wherein the flexible conductive path includes a second conductive path electrically connected between the wireless charging circuit and the conductive pattern, and a third conductive path electrically connected between the communication circuit and the first conductive path.

US 20130162485A1 discloses a handheld electronic device that contains a conductive housing and other conductive elements. The conductive elements may form an antenna ground plane. One or more antennas for the handheld electronic device may be formed from the ground plane and one or more associated antenna resonating elements. Transceiver circuitry may be connected to the resonating elements by transmission lines such as coaxial cables. Ferrules may be crimped to the coaxial cables. A bracket with extending members may be crimped over the ferrules to ground the coaxial cables to the housing and other conductive elements in the ground plane. The ground plane may contain an antenna slot. A dock connector and flex circuit may overlap the slot in a way that does not affect the resonant frequency of the slot. Electrical components may be isolated from the antenna using isolation elements such as inductors and resistors.

### [Disclosure]

### [Technical Solution]

The scope of the present invention is determined according to the independent claim. Various embodiments of the present invention are outlined in the dependent claims.

Also disclosed herein is an electronic device comprising a housing including a first surface, a second surface facing away from the first surface, and a third surface disposed between the first surface and the second surface. The electronic device comprises a display disposed on the first surface of the housing. The electronic device comprises a processor to display an image on the display. The electronic device comprises communication circuitry connected to the processor. The electronic device comprises a printed circuit board (PCB) including an electronic component that is connected to the processor independently of the communication circuitry, and is disposed on a surface directing the third surface. The PCB of the electronic device may include a conductive pattern formed on the surface of the PCB directing to the third surface, and coupled to a feeding line extending from the communication circuit. The PCB of the electronic device may be disposed adjacent to the third surface.

Also disclosed herein is that an electronic device may comprise a first housing. The electronic device may comprise a second housing, movably coupled to the first housing and including a first surface, a second surface facing away from the first surface, and a third surface disposed between the first surface and the second surface, wherein a mic-hole is formed in the second housing. The electronic device may include a displaying area extending from the first surface of the second housing to a surface of the first housing, and may include a display insertable into or extractable from the second housing. The electronic device may include a printed circuit board (PCB). The PCB may include a conductive pattern formed on a surface of the PCB directing the third surface and at least partially forming an antenna structure. The surface of the PCB on which the conductive pattern is formed may be disposed adjacent to the third surface.

Also disclosed herein is that an electronic device may comprise a communication processor. The electronic device may comprise a housing including a first surface, a second surface facing away from the first surface, and a third surface disposed between the first surface and the second surface. The electronic device may comprise a display disposed on the first surface of the housing. The electronic device may comprise a printed circuit board (PCB). The PCB of the electronic device may include a conductive pattern coupling with a conductive portion in the housing, connected to a feeding line extending from the communication circuit, and formed on a surface of the PCB directing the third surface. The surface of the PCB on which the conductive pattern is formed may be disposed adjacent to the third surface.

### [Description of the Drawings]

FIG. 1 is a block diagram of an electronic device in a network environment according to an embodiment.
FIG. 2 is a block diagram of an electronic device according to an embodiment.
FIGS. 3A to 3C are exemplary diagrams for describing a disposition of a printed circuit board (PCB) in which at least one conductive pattern related to an antenna structure is formed in an electronic device according to an embodiment.
FIGS. 4A to 4C are exemplary diagrams for describing a disposition of a PCB in which at least one conductive pattern related to an antenna structure is formed in an embodiment of a deformable electronic device.
FIGS. 5A to 5G are exemplary diagrams for describing a conductive pattern formed on a PCB included in an electronic device according to an embodiment.
FIGS. 6A to 6C are exemplary diagrams for describing an antenna structure based on the conductive pattern exemplified in FIG. 5A.
FIGS. 7A to 7D are exemplary diagrams for describing an antenna structure formed by a conductive pattern formed on a PCB included in an electronic device and another conductive pattern included in a housing of the electronic device according to an embodiment.
FIG. 8 is an exemplary diagram for describing an antenna structure based on the conductive pattern exemplified in FIG. 7C.
FIG. 9 is a diagram for describing an example of a circuit including an electronic component included in a PCB of an electronic device according to an embodiment.
FIG. 10A is a front view of a first state of an electronic device according to an embodiment.
FIG. 10B is a rear view of a first state of an electronic device according to an embodiment.
FIG. 10C is a front view of a second state of an electronic device according to an embodiment.
FIG. 10D is a rear view of a second state of an electronic device according to an embodiment.
FIG. 11A is an exploded perspective view of an electronic device according to an embodiment.
FIG. 11B is a cross-sectional view illustrating an example of an electronic device according to an embodiment, cut along line A-A' of FIG. 15A.
FIG. 12 is a front view of a second state indicating a boundary portion of a display of an electronic device according to an embodiment.

### [Mode for Invention]

Hereinafter, various embodiments of the present document will be described with reference to the accompanying drawings.

The various embodiments of the present document and terms used herein are not intended to limit the technology described in the present document to specific embodiments, and should be understood to include various modifications, equivalents, or substitutes of the corresponding embodiment. In relation to the description of the drawings, a reference numeral may be used for a similar component. A singular expression may include a plural expression unless it is clearly meant differently in the context. In the present document, an expression such as "A or B", "at least one of A and/or B", "A, B or C", or "at least one of A, B and/or C", and the like may include all possible combinations of items listed together. Expressions such as "1st", "2nd", "first" or "second", and the like may modify the corresponding components regardless of order or importance, is only used to distinguish one component from another component, but does not limit the corresponding components. When a (e.g., first) component is referred to as "connected (functionally or communicatively)" or "accessed" to another (e.g., second) component, the component may be directly connected to the other component or may be connected through another component (e.g., a third component).

The term "module" used in the present document may include a unit configured with hardware, software, or firmware, and may be used interchangeably with terms such as logic, logic block, component, or circuit, and the like. The module may be an integrally configured component or a minimum unit or part thereof that performs one or more functions. For example, a module may be configured with an application-specific integrated circuit (ASIC).

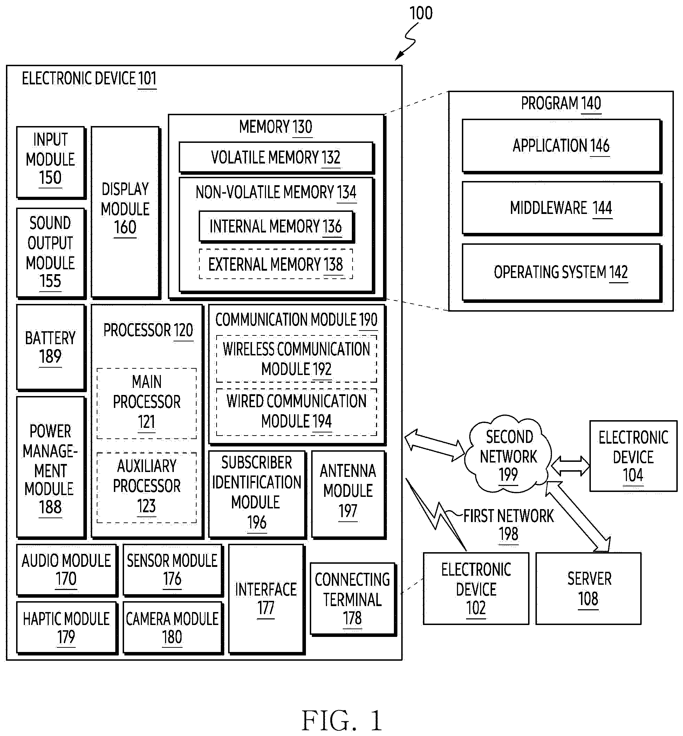

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

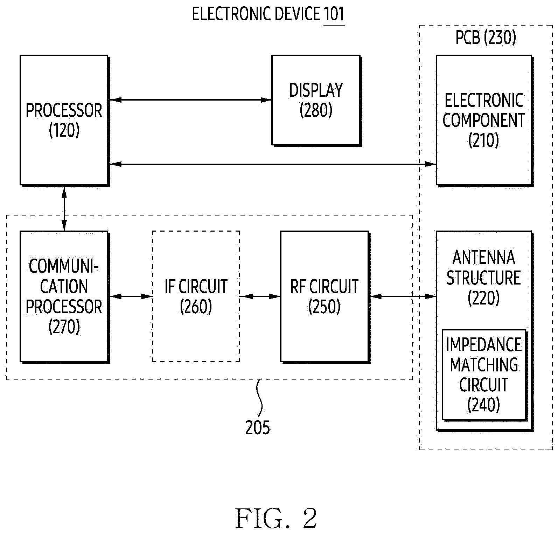

FIG. 2 is a block diagram of an electronic device 101 according to an embodiment. The electronic device 101 of FIG. 1 may be an example of the electronic device 101 of FIG. 2. The electronic device 101 according to an embodiment may be a terminal owned by a user. The terminal may include, for example, a personal computer (PC) such as a laptop or a desktop, a smartphone, a smartpad, a tablet PC, a smartwatch, and/or a smart accessory such as a head-mounted device (HMD).

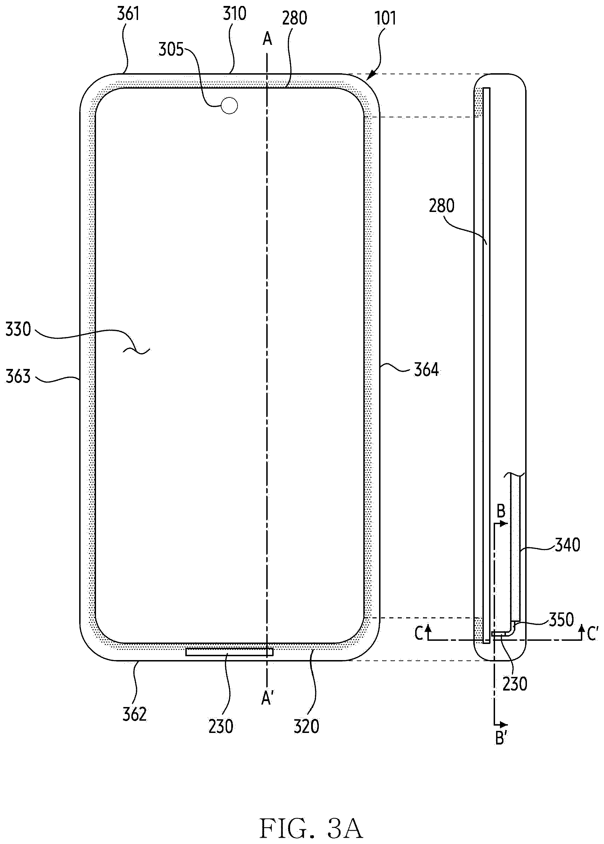

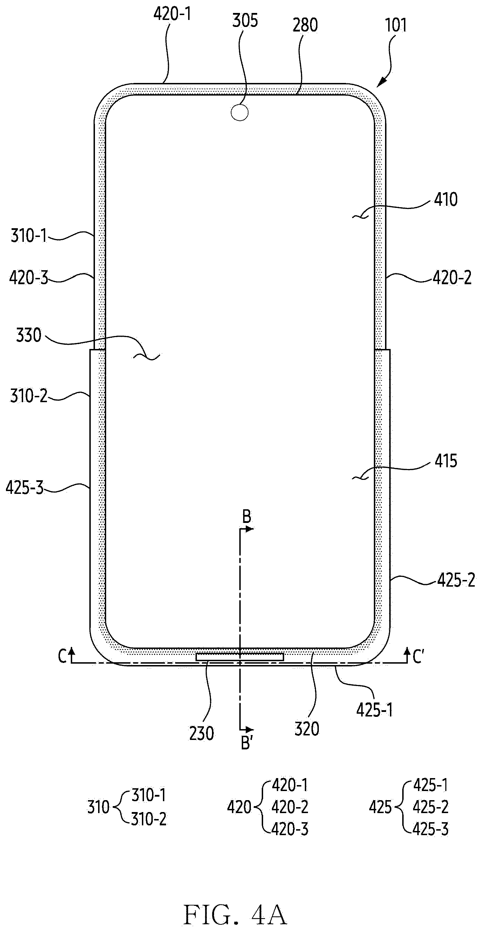

Referring to FIG. 2, the electronic device 101 according to an embodiment may include at least one of a processor 120, a display 280, an electronic component 210, an antenna structure 220, an impedance matching circuit 240, an RF circuit 250, an IF circuit 260, or a communication processor 270. The processor 120, the display 280, the electronic component 210, the antenna structure 220, the impedance matching circuit 240, the RF circuit 250, the IF circuit 260, and the communication processor 270 may be electronically and/or operably coupled with each other by an electronical component such as a communication bus (not illustrated). Although illustrated based on different blocks, an embodiment is not limited thereto, and a portion (e.g., at least a portion of the processor 120 and the communication processor 270) of hardware components illustrated in FIG. 2 may be included in a single integrated circuit such as a system on a chip (SoC). The type and/or number of hardware components included in the electronic device 101 is not limited as illustrated in FIG. 2. For example, the electronic device 101 may include only a portion of the hardware components illustrated in FIG. 2. According to an embodiment, the electronic device 101 may include one or more housings for accommodating at least one of the hardware components of FIG. 2. An example of the one or more housings will be described later with reference to FIGS. 3A to 3C and/or 4A to 4C.

According to an embodiment, the processor 120 of the electronic device 101 may include a hardware component for processing data based on one or more instructions. For example, the hardware component for processing data may include an arithmetic and logic unit (ALU), a floating point unit (FPU), a field programmable gate array (FPGA), and/or a central processing unit (CPU). The number of processors 120 may be one or more. For example, the processor 120 may have a structure of a multi-core processor such as a dual core, a quad core, or a hexa core. The processor 120 in FIG. 2 may comprise the processor 120 in FIG. 1. In an embodiment, the processor 120 may be referred to as an application processor (AP).

According to an embodiment, the display 280 of the electronic device 101 may output visualized information to the user. For example, the display 280 may output visualized information to the user, by being controlled by the processor 120. The display 280 may include a flat panel display (FPD) and/or electronic paper. For example, the FPD may include a liquid crystal display (LCD), a plasma display panel (PDP), and/or one or more light emitting diodes (LEDs). The LED may include an organic LED (OLED). In an embodiment, the display 280 of the electronic device 101 may be a deformable flexible display. In an embodiment in which the display 280 is a flexible display, the electronic device 101 may include a driving unit assembly for deforming the electronic device 101 and/or the display 280. An embodiment in which the display 280 is a flexible display will be described later with reference to FIGS. 4A to 4C.

The display 280 of the electronic device 101 according to an embodiment may include a sensor (e.g., a touch sensor panel (TSP)) for detecting an external object (e.g., a user's finger) on the display 280. For example, based on the TSP, the electronic device 101 may detect an external object contacting the display 280 or floating above the display 280. In response to detecting the external object, the electronic device 101 may execute a function related to a specific visual object corresponding to a position of the external object on the display 280, among visual objects being displayed in the display 280.

The communication circuit 205 of the electronic device 101 according to an embodiment may include a hardware component for supporting the exchange of an electric signal between the electronic device 101 and an external electronic device different from the electronic device 101. Referring to FIG. 2, the communication circuit 205 of the electronic device 101 may include the communication processor 270, the IF circuit 260, and the RF circuit 250. For example, the communication circuit 205 may include at least one of a MODEM, an antenna, and an optic/electronic (O/E) converter. The communication circuit 205 may support transmission and/or reception of an electric signal based on various types of protocols such as ethernet, local area network (LAN), wide area network (WAN), wireless fidelity (WiFi), bluetooth, bluetooth low energy (BLE), ZigBee, long term evolution (LTE), or 5G new radio (NR). The hardware component included in the communication circuit 205 is not limited to FIG. 2. For example, based on a frequency band supported by the communication circuit 205, the IF circuit 260 included in the communication circuit 205 may be omitted.

The communication processor 270 of the electronic device 101 according to an embodiment may control another circuit connected to the communication processor 270 within the communication circuit 205. For example, in response to receiving a request for data transmission from the processor 120, the communication processor 270 may output an electric signal in a baseband indicating the data to the IF circuit 260. The IF circuit 260 of the electronic device 101 according to an embodiment may obtain an electric signal in an intermediate frequency band, from the electric signal in the base band received from the communication processor 270. In response to obtaining the electric signal in the intermediate frequency band, the IF circuit 260 may output the obtained electric signal to the RF circuit 250. In response to receiving the electric signal in the intermediate frequency band from the IF circuit 260, the RF circuit 250 may change the electric signal in the intermediate frequency band to an electric signal in a radio frequency band.

In an embodiment, the radio frequency band may be associated with a standard (e.g., second generation (2G), third generation (3G), fourth generation (4G), fifth generation (5G), and/or sixth generation (6G)) of a cellular network (e.g., the second network 199 of FIG. 1). For example, the radio frequency band may be a radio frequency band defined in the 5G, and include a low band (LB) band between 600 MHz and 700 MHz, a mid-band (MB) band between 1 GHz and 2 GHz, a high band (HB) band between 2 GHz and 3 GHz (e.g., n77 band between 3300 MHz and 4200 MHz), a Sub-6 band between 3 GHz and 6 GHz, and/or a mmWave band above 28 GHz. For example, the radio frequency band may include an ultra-wideband (UWB) band between 3.1 GHz and 10.6 GHz. For example, the radio frequency band may include a band in 2.4 GHz or between 5 GHz and 6 GHz, related to WiFi 6 (or IEEE 802.11ax).

In an embodiment, the baseband, the intermediate frequency band, and the radio frequency band may be spaced apart from each other in a frequency domain. For example, the intermediate frequency band may be a frequency band less than the radio frequency band. For example, the baseband may be a frequency band that is less than the intermediate frequency band and includes 0 GHz.

In response to obtaining the electric signal in the radio frequency band, the RF circuit 250 may output the electric signal in the radio frequency band to the antenna structure 220. While the RF circuit 250 applies the electric signal to the antenna structure 220, a wireless signal may be outputted from the antenna structure 220. While the electric signal is applied to the antenna structure 220, the impedance matching circuit 240 may adjust a gain between the electric signal outputted from the RF circuit 250 and the wireless signal outputted from the antenna structure 220, by reducing a reflection loss of the antenna structure 220.

An embodiment in which the electronic device 101 transmits a wireless signal to an external electronic device using the antenna structure 220 has been described, but the embodiment is not limited thereto. For example, the antenna structure 220 may receive an electric signal in a radio frequency band based on a wireless signal transmitted from an external electronic device different from the electronic device 101. The electric signal in the radio frequency band received by the antenna structure 220 may be outputted to the RF circuit 250. The RF circuit 250 may change the electric signal in the radio frequency band outputted from the antenna structure 220 to an electric signal in an intermediate frequency band. The RF circuit 250 may transmit the changed electric signal to the IF circuit 260. The IF circuit 260 may change the electric signal in the intermediate frequency band transmitted from the RF circuit 250 to an electric signal in the base band. The IF circuit 260 may output the electric signal in the baseband to the communication processor 270. The communication processor 270 may transmit data included in the electric signal in the baseband, which is outputted from the IF circuit 260, to the processor 120.

The antenna structure 220 of the electronic device 101 according to an embodiment may include one or more conductive patterns. For example, the antenna structure 220 may support multiple-input and multiple-output (MIMO). For example, it may operate as an antenna structure 220 that supports multiple-input and multiple-output (4RX-MIMO) including a specified number (e.g., 4) of receiving antennas.

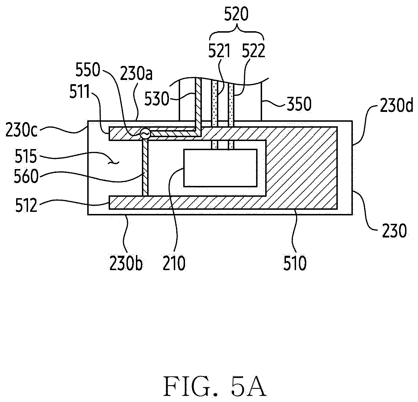

According to an embodiment, the one or more conductive patterns may be disposed adjacent to a surface of a housing of the electronic device 101. For example, the one or more conductive patterns may be disposed within the electronic device 101 toward a surface of a housing of the electronic device 101. A conductive pattern included in the antenna structure 220 and disposed within the electronic device 101 toward a surface of a housing of the electronic device 101 will be described later with reference to FIGS. 5A to 5G.

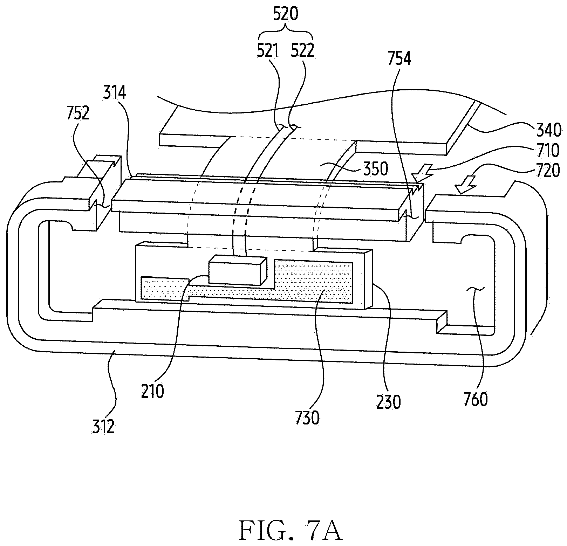

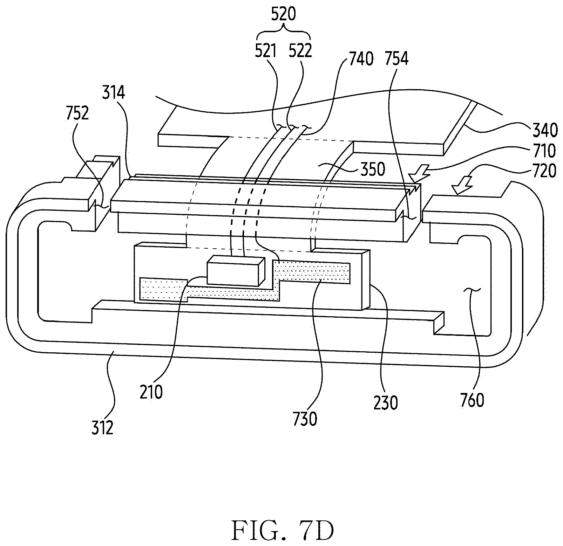

**In** an embodiment in which the antenna structure 220 includes a plurality of conductive patterns, a first conductive pattern among the plurality of conductive patterns may be disposed on a surface of a housing. At least a portion of a second conductive pattern among the plurality of conductive patterns may be disposed within the electronic device 101 toward the surface of the housing. The antenna structure 220 formed by the first conductive pattern and the second conductive pattern will be described later with reference to FIGS. 7A to 7D.

According to an embodiment, an electronic component 210 of the electronic device 101 may be controlled by the processor 120. Referring to FIG. 2, according to an embodiment, the electronic device 101 may include a printed circuit board (PCB) 230 on which the electronic component 210 and at least a portion of the antenna structure 220 are disposed. For example, at least one conductive pattern at least partially forming the antenna structure 220 controlled by the communication circuit 205 may be disposed on the PCB 230 of the electronic device 101, together with the electronic component 210. The electronic component 210 may have a structure for preventing performance degradation of the antenna structure 220 due to an electric signal in a radio frequency band (hereinafter, RF signal) generated from the electronic component 210.

According to an embodiment, a surface of the PCB 230 on which the electronic component 210 and at least a portion of the antenna structure 220 are disposed may be disposed within the electronic device 101 toward a surface of the housing of the electronic device 101, in order to support the exchange of a wireless signal based on the at least a portion of the antenna structure 220. For example, a surface of the housing of the electronic device 101 may be connected to another surface where the display 280 is exposed to the outside, within the housing of the electronic device 101. For example, in case that the other surface where the display 280 is exposed to the outside is referred to as a front surface, the surface of the electronic device 101 to which the one or more conductive patterns is directed may be referred to as a side surface. For example, a surface of the PCB 230 on which the electronic component 210 and at least a portion of the antenna structure 220 are disposed may be disposed toward the side surface of the housing of the electronic device 101.

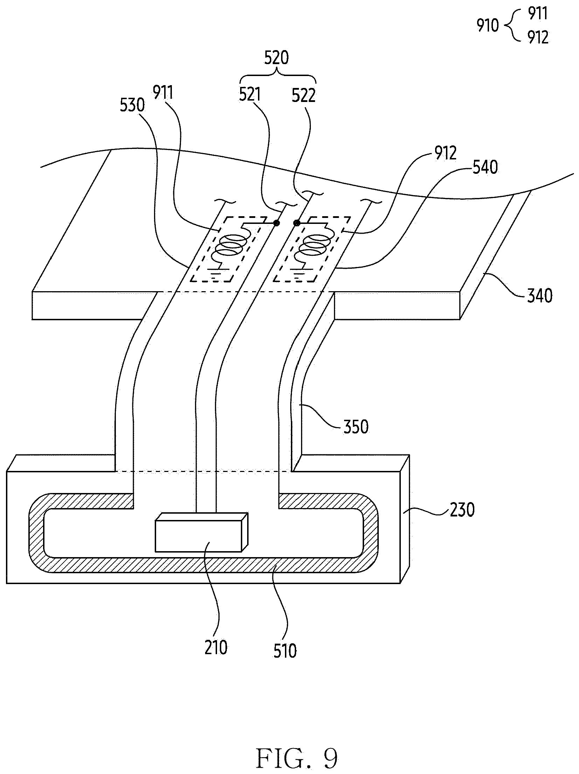

**In** an embodiment, the electronic component 210 disposed on the PCB 230 together with at least a portion of the antenna structure 220 may include a microphone that outputs an electric signal indicating vibration of the atmosphere. For example, the electronic device 101 may obtain an audio signal including a user's speech using the microphone. The user's speech included in the audio signal may be converted into information of a format recognizable by the electronic device 101, based on a voice recognition model and/or a natural language understanding model. For example, the electronic device 101 may execute one or more functions among a plurality of functions that may be provided by the electronic device 101, by recognizing the user's speech. A structure for preventing interference between a conductive line connecting an electronic component 210 including the microphone and the processor 120 and a conductive line extending from a portion of the antenna structure 220 included in the PCB 230 will be described later with reference to FIG. 9.

The electronic component 210 disposed on the PCB 230 together with at least a portion of the antenna structure 220 is not limited to the microphone. For example, the electronic component 210 may include an interface for supporting wired communication between the electronic device 101 and an external electronic device. The interface may include a hardware component (e.g., connector) for supporting wired communication such as USB port and/or COM port. For example, the electronic component 210 may include a speaker for outputting an acoustic signal from an electric signal transmitted from the processor 120. For example, the electronic component 210 may include another output means for outputting information in a form other than a visual form and an audible form. For example, the other output means may include one or more motors for providing haptic feedback based on vibration.

Although an example in which the PCB 230 includes the electronic component 210 and at least a portion of the antenna structure 220 is illustrated, the embodiment is not limited thereto. For example, the PCB 230 may further include the processor 120 and/or at least a portion of the communication circuit 205, as well as the electronic component 210 and the antenna structure 220. In the example, on the PCB 230, a first portion in which the electronic component 210 and the antenna structure 220 are integrated may be disposed toward a side surface (e.g., a lower surface) of the housing of the electronic device 101. In the example in which the first portion is disposed toward the side surface, a second portion of the PCB 230, which is different from the first portion, may be disposed toward a front surface (or a rear surface faced away from the front surface) of the housing of the electronic device 101. The processor 120 and/or at least a portion of the communication circuit 205 may be disposed on a surface of the second portion disposed toward the front surface of the housing.

In an embodiment, the number of the PCB included in the electronic device 101 may be a plurality. For example, in case that the PCB 230, on which the electronic component 210 and the antenna structure 220 are integrated, disposed toward a side surface (e.g., a lower surface) of the housing of the electronic device 101, is referred to as a first PCB, the electronic device 101 may include a second PCB on which an impedance matching circuit 240 and a portion of the RF circuit 250 are disposed, and a third PCB on which another portion of the RF circuit 250 different from the portion of the RF circuit 250, the IF circuit 260, the communication processor 270, and/or the processor 120 are disposed, together with the first PCB. In the example, the second PCB and/or the third PCB may be disposed toward the front surface (or rear surface) of the housing of the electronic device 101. In the example, a portion of the RF circuit 250 disposed on the second PCB may include a low-noise amplifier (LNA). In the example, the first PCB, the second PCB, and the third PCB may be interconnected through one or more flexible PCBs and/or one or more conductive lines. In the example, the third PCB on which the processor 120 is disposed may be referred to as a main PCB, and the second PCB may be referred to as a sub-PCB.

As described above, since the electronic device 101 includes the PCB 230 in which at least a portion of the antenna structure 220 operably connected to the communication circuit 205 and the electronic component 210 operably connected to the processor 120 are integrated, the electronic device 101 may be implemented independently of another PCB dedicated to form an antenna structure, and a laser direct structuring (LDS) antenna. Since it is implemented independently of the other PCB and the LDS antenna, spatial efficiency of the electronic device 101 may be increased. For example, as another hardware component is disposed in a space on which the other PCB and the LDS antenna are to be disposed, degree of freedom in design of the electronic device 101 may be increased.

Hereinafter, referring to FIGS. 3A to 3C and/or 4A to 4C, a positional relationship between the PCB 230 on which all of the electronic component 210 and at least a portion of the antenna structure 220 are disposed and the housing of the electronic device 101 will be described.

FIGS. 3A to 3C are exemplary diagrams for describing a disposition of a printed circuit board (PCB) 230 in which at least one conductive pattern related to an antenna structure is formed in an electronic device 101 according to an embodiment. The electronic device 101 of FIGS. 3A to 3C may be an example of the electronic device 101 of FIG. 2. For example, the PCB 230 and the display 280 of FIG. 2 may include a PCB 230 and a display 280 of FIGS. 3A to 3C.

Referring to FIGS. 3A to 3C, a housing 310 of the electronic device 101 according to an embodiment is illustrated. The housing 310 may include a plurality of members, which are coupled to each other to form an inner space of the electronic device 101. Referring to FIG. 3A, an outline of the electronic device 101 formed by the housing 310 based on a rectangular shape is illustrated. The housing 310 may include a rounded corner. In an embodiment, the housing 310 may include a first surface, a second surface faced away from the first surface, and a third surface disposed between the first surface and the second surface. According to an embodiment, the display 280 of the electronic device 101 may be disposed on the first surface of the housing 310. For example, the first surface where the display 280 is disposed and is at least partially viewed to the outside may be referred to as a front surface of the electronic device 101. In the example, the second surface may be referred to as a rear surface of the electronic device 101. In the example, the third surface may be referred to as a side surface of the electronic device 101.

Referring to FIG. 3A, a front view of the electronic device 101 for describing the front surface of the electronic device 101 according to an embodiment is illustrated. The electronic device 101 according to an embodiment may include a side member 320 disposed on the front surface of the housing 310 of the electronic device 101. Referring to FIG. 3A, the side member 320 may be formed along a periphery of the display 280. For example, the side member 320 may cover the periphery and/or an edge of the display 280. In an embodiment, the side member 320 superimposed on the display 280 may be referred to as a black margin and/or a black matrix.

**In** an embodiment, a displaying area 330 of the display 280 may be an area in which the display 280 is exposed to the outside. For example, the displaying area 330 may be at least a portion of the display 280 distinguished by one or more viewable pixels among pixels included in the display 280. Referring to FIG. 3A, the displaying area 330 of the display 280 may be another portion different from a portion of the display 280 covered by the side member 320. In an embodiment, the displaying area 330 may have a rectangular shape including a rounded corner based on a shape of the side member 320.

According to an embodiment, the electronic device 101 may include a camera 305 disposed toward the first surface (e.g., the front surface) on which the display 280 is disposed. For example, the camera 305 may transmit data based on light directing the first surface to the processor 120 of FIG. 2. Referring to FIG. 3A, a camera 305 disposed in a perforated opening of the display 280 is illustrated. A position of the camera 305 in the first surface is not limited to those illustrated in FIG. 3A. For example, the camera 305 may be disposed on a portion of the first surface spaced apart from the display 280 and/or the displaying area 330. For example, the camera 305 may be disposed under the display 280 when viewed from the front of the electronic device 101.

Referring to FIG. 3A, the PCB 230 of the electronic device 101 according to an embodiment may be disposed toward the third surface among the first to third surfaces of the housing 310. At least one conductive pattern included in an antenna structure (e.g., the antenna structure 220 of FIG. 2) formed by at least a portion (e.g., the impedance matching circuit 240 of FIG. 2) of a communication circuit (e.g., the communication circuit 205 of FIG. 2) of the electronic device 101 may be disposed adjacent to a surface disposed toward the third surface of the PCB 230 or on the surface. For example, referring to FIG. 3A, when viewed from the front of the electronic device 101, the side member 320 and the PCB 230 may be at least partially superimposed. According to an embodiment, the PCB 230 may be disposed between an edge of the displaying area 330 and an edge (e.g., an edge where the first surface and the third surface meet) between the first surface and the third surface of the housing 310, distinguished by the side member 320. As another example, when viewed from the front of the electronic device 101, the PCB 230 may be disposed adjacent to the third surface.

Referring to FIG. 3A, the side surface (e.g., the third surface) of the housing 310 may be distinguished into four portions based on a corner. The four portions of the side surface may include each of four edges 361, 362, 363, and 364 of the front surface of the housing 310. Referring to FIG. 3A, the four edges of the front surface of the housing 310 may include a first edge 361 closest to the camera 305, a second edge 362 faced away from the first edge, a third edge 363 extending from an end of the first edge to an end of the second edge, and a fourth edge 364 extending from another end of the first edge to another end of the second edge. In an embodiment, a portion of the side surface adjacent to the PCB 230 may include the second edge 362. For example, a portion of the side surface closest to the PCB 230 may be a portion farthest from the camera 305 among the four portions of the side surface. For example, a surface of the PCB 230 on which at least one conductive pattern is disposed may be disposed toward a portion of the side surface of the housing 310 that is farthest from the camera 305. For example, among the four portions of the side surface, the portion farthest from the camera 305 may be referred to as a lower surface. A portion on which the PCB 230 is disposed is not limited to the example, and may be disposed on other portions of the side surface.

Referring to FIG. 3A, a cross-sectional view of A-A' of the front view of the electronic device 101 according to an embodiment is illustrated. Referring to the cross-sectional view of FIG. 3A, the electronic device 101 according to an embodiment may include an FPCB 350 connected to the PCB 230. According to an embodiment, the electronic device 101 may include the PCB 340 connected to the FPCB 350. For example, the PCB 340 may include the sub-PCB and/or the main PCB of FIG. 2. The PCB 340 may include a surface disposed toward the first surface (e.g., the front surface) of the electronic device 101. In an embodiment, at least a portion of the processor 120 of FIG. 2 and/or the communication circuit 205 of FIG. 2 may be disposed on the surface of the PCB 340 or another surface different from the surface. Another surface faced away from the surface of the PCB 340 may be attached to an inner surface of the second surface (e.g., the rear surface) of the housing 310.

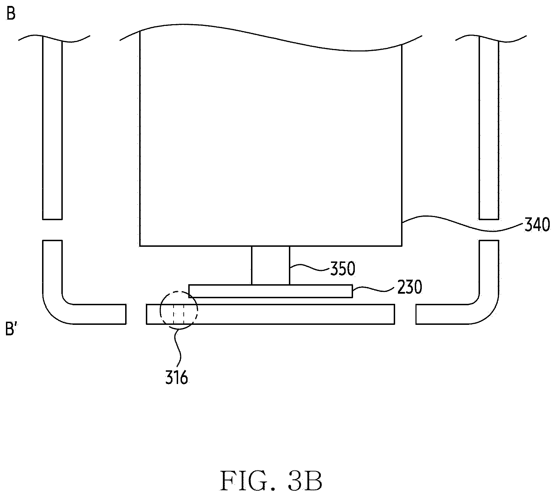

Referring to FIG. 3B, a perspective view of B-B' of the electronic device 101 of FIG. 3A is illustrated. The side surface of the housing 310 of the electronic device 101 according to an embodiment may include a mic-hole 316 perforated to receive an acoustic signal. In an embodiment in which the electronic component 210 disposed on a surface of the PCB 230 includes a microphone, the surface of the PCB 230 may be disposed toward the mic-hole 316. For example, a direction of a normal line of the surface of the PCB 230 may be substantially parallel to a direction of the mic-hole 316. For example, among the side surface of the housing 310, a portion including the mic-hole 316 may be referred to as a lower surface. In an embodiment, a waterproof membrane may be filled in the mic-hole 316.

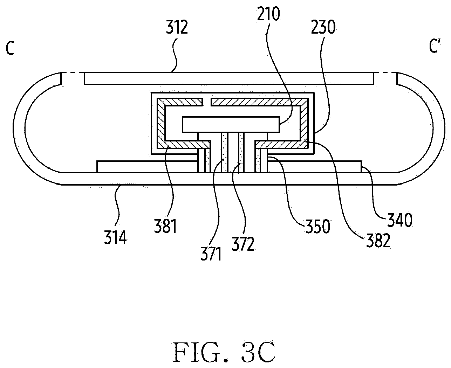

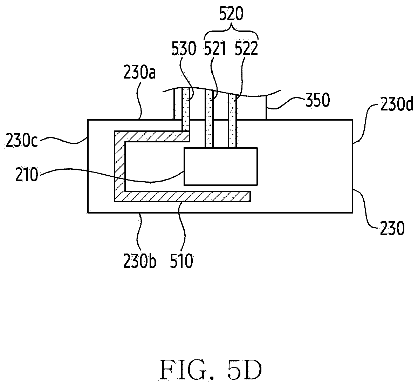

Referring to FIG. 3C, a perspective view of C-C' of the electronic device 101 of FIG. 3A is illustrated. The FPCB 350 includes one or more conductive lines (e.g., conductive lines 371 and 372) for interconnecting the electronic component 210 on the PCB 230 and a hardware component (e.g., the processor 120 of FIG. 2) on the PCB 340. On a surface of the PCB 230, the electronic component 210 disposed together with the conductive pattern (e.g., the conductive patterns 381 and 382) is connected to a processor (e.g., the processor 120 of FIG. 2) of the electronic device 101, through a signal path formed by the one or more conductive lines and independent of the conductive pattern. The FPCB 350 may further include one or more conductive lines connected to at least one conductive pattern on the PCB 230 at least partially forming an antenna structure (e.g., the antenna structure 220 of FIG. 2) and connected to an impedance matching circuit (e.g., the impedance matching circuit 240 of FIG. 2) on the PCB 340. Referring to FIG. 3C, an example of a conductive pattern based on FIG. 5D to be described below is illustrated, but the embodiment is not limited thereto. Referring to FIG. 3C, a conductive pattern (e.g., conductive patterns 381 and 382) may be formed on a layer included in the PCB 230. Another layer of the PCB 230 on which an insulator is formed may be superimposed on the layer.

According to an embodiment, an antenna structure (e.g., the antenna structure 220 of FIG. 2) of the electronic device 101 may be formed based on a conductive pattern included in the PCB 230 and/or a conductive portion formed in the housing 310. Referring to FIG. 3C, conductive portions 312 and 314 of the housing 310 for at least partially forming the antenna structure are illustrated. For example, each of the conductive portions 312 and 314 may be referred to as different metal frames included in the housing 310. For example, the conductive portion 312 may be formed on the housing 310 of the electronic device 101 along an edge between the front surface and the lower surface. For example, the conductive portion 314 may include an edge between the lower surface and the rear surface of the housing 310 of the electronic device 101, and may be formed along another edge different from the edge of the lower surface on which the conductive portion 312 is formed.

Although an embodiment in which the electronic device 101 includes PCBs 230 and 340 and the FPCB 350 connecting the PCBs 230 and 340 is illustrated, the embodiment is not limited thereto. For example, the electronic device 101 may include an integrated PCB that includes a first portion directing the lower surface of the electronic device 101 such as the PCB 230, a second portion directing the front surface of the electronic device 101 such as the FPCB 350, and a third portion bent to connect the first portion and the second portion such as the FPCB 350.

As described above, the electronic device 101 according to an embodiment may form an antenna structure using the PCB 230 disposed toward a specific portion (e.g., the lower surface) of the side surface. The electronic device 101 may form the antenna structure using at least one conductive pattern formed on the PCB 230 including the electronic component 210, independent of exchange of a wireless signal. Since the electronic device 101 forms the antenna structure using the PCB 230 including the electronic component 210, the electronic device 101 may be designed or implemented independently of an additional PCB for forming the antenna structure or an LDS antenna. When the electronic device 101 is produced without the additional PCB, the production cost of the electronic device 101 may be reduced.

The electronic device 101 according to an embodiment may include a plurality of housings to support deformability. Hereinafter, a PCB 230 included in an embodiment of a deformable electronic device 101 will be described with reference to FIGS. 4A to 4C.

FIGS. 4A to 4C are exemplary diagrams for describing a disposition of a PCB 230 in which at least one conductive pattern related to an antenna structure is formed in an embodiment of a deformable electronic device 101. The electronic device 101 of FIGS. 4A to 4C may be an example of the electronic device 101 of FIGS. 2 and/or 3A to 3C. For example, the PCB 230 and the display 280 of FIG. 2 may include the PCB 230 and the display 280 of FIGS. 4A to 4C. For example, the housing 310, the side member 320, the displaying area 330, the PCB 340, and the FPCB 350 of FIGS. 3A to 3C may include a housing 310, a side member 320, a displaying area 330, a PCB 340, and a FPCB 350 of FIGS. 4A to 4C. Hereinafter, descriptions overlapping with FIGS. 1, 2, 3A to 3C are omitted.

Referring to FIGS. 4A to 4C, the housing 310 of the electronic device 101 may include a first housing 310-1 and a second housing 310-2 based on deformability. For example, the housing 310 forming an outline of the electronic device 101 may include the first housing 310-1 and the second housing 310-2, which are movably combined. Although not illustrated, the electronic device 101 may include a guide assembly guiding movement of the first housing 310-1 and the second housing 310-2.

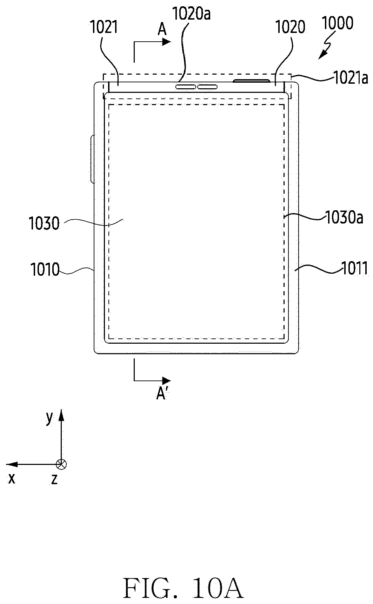

For example, the guide assembly may include a driving unit assembly that guides movement of the first housing 310-1 and the second housing 310-2 caused by external force. For example, the driving unit assembly may guide the movement of the first housing 310-1 and the second housing 310-2, based on movement of an actuator (e.g., motor) controlled by a processor (e.g., the processor 120 of FIG. 2). In the example, the first housing 310-1 and the second housing 310-2 may be coupled to be slidable or rollable by the driving unit assembly. An example of the guide assembly will be described below with reference to FIGS. 10A to 10D, 11A to 11B, and/or FIG. 12.

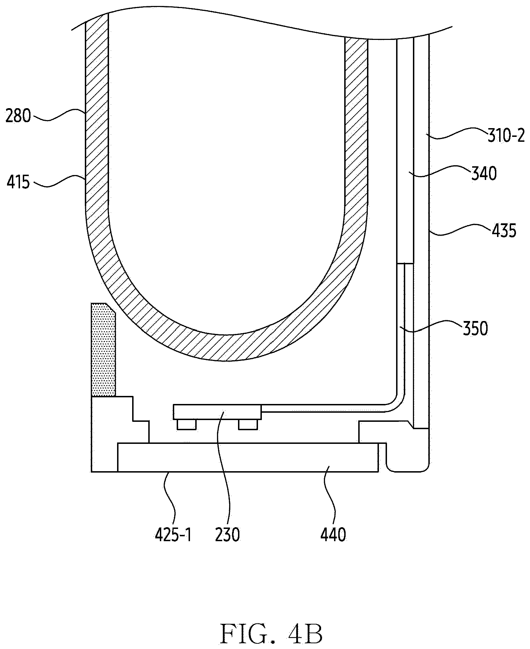

Referring to FIGS. 4A to 4B, according to an embodiment, the first housing 310-1 may be coupled to the second housing 310-2 to be insertable into the second housing 310-2 or extractable from the second housing 310-2. Dimensions such as a width and/or a height of the front surface of the electronic device 101 may be adjusted based on the first housing 310-1 and the second housing 310-2, which are movably coupled. Based on the first housing 310-1 and the second housing 310-2, which are movably coupled, a surface area and/or a volume of the housing 310 of the electronic device 101 may be adjusted. In an embodiment, the first housing 310-1 may include a second surface (e.g., rear surface) faced away from a first surface 410 (e.g., front surface) of the first housing 310-1, and a third surface 420 (e.g., side surface) disposed between the first surface of the first housing 310-1 and the second surface of the first housing 310-1. In an embodiment, the second housing 310-2 may include a second surface (e.g., a second surface 435 of FIG. 4B) (e.g., rear surface) faced away from a first surface 415 of the second housing 310-2 and a third surface 425 (e.g., side surface) disposed between the first surface of the second housing 310-2 and the second surface of the second housing 310-2. Referring to FIG. 4A, the third surface 420 of the first housing 310-1 may include a first side surface 420-1, a second side surface 420-2, and a third side surface 420-3. The third surface 425 of the second housing 310-2 may include a first side surface 425-1, a second side surface 425-3, and a third side surface 425-3.

According to an embodiment, the display 280 of the electronic device 101 may be disposed across the first housing 310-1 and the second housing 310-2. For example, the display 280 may extend from the first surface 415 (e.g., front surface) of the second housing 310-2 to the first surface 410 (e.g., front surface) of the first housing 310-1. A shape of the display 280 may be changed by the first housing 310-1 and the second housing 310-2, which are movably coupled. For example, the display 280 may be insertable into the second housing 310-2 or extractable from the second housing 310-2. Within the display 280, a width and/or a height of an area exposed to the outside may be changed based on the insertion of the display 280 into the second housing 310-2 or the extraction of the display 280 from the second housing 310-2.

Referring to FIG. 4A, according to an embodiment, a front view of the electronic device 101 for describing the front surface of the electronic device 101 formed by the first housing 310-1 and the second housing 310-2 is illustrated. According to an embodiment, the side member 320 of the electronic device 101 may be formed along a periphery of an area of the display 280 exposed to the outside by the first housing 310-1 and the second housing 310-2. The displaying area 330 of the display 280 may be another portion different from a portion of the display 280 occluded by the side member 320, the first housing 310-1, and the second housing 310-2. At least a portion of the display 280 corresponding to the displaying area 330 may be flatly disposed on the front surface of the first housing 310-1 and the front surface of the second housing 310-2. For example, the side member 320 may be disposed between the second housing 310-2 and the display 280 so that a rolled portion of the display 280 based on the insertion of the display 280 into the second housing 310-2 is occluded. A thickness and/or area of the side member 320 may be related to a size and/or curvature of the rolled portion of the display 280.

In an embodiment, dimensions such as a width and/or a height of the displaying area 330 of the display 280 may be adjusted based on the first housing 310-1 and the second housing 310-2, which are movably coupled. For example, as the first housing 310-1 is inserted into the second housing 310-2, an area of the displaying area 330 may be minimized in a first state that an area of the first housing 310-1 exposed to the outside is minimized. The first state may be referred to as a rolled state and/or a slide-in state. For example, as the first housing 310-1 is extracted from the second housing 310-2, an area of the displaying area 330 may be maximized in a second state that an area of the first housing 310-1 exposed to the outside is maximized. The second state may be referred to as an unrolled state and/or a slide-out state. For another example, the electronic device 101 may include a third state between the first state and the second state.

According to an embodiment, the PCB 230 of the electronic device 101 may be disposed toward one of a side surface of the first housing 310-1 or a side surface of the second housing 310-2. Referring to FIG. 3A, an embodiment in which the PCB 230 is disposed toward the side surface of the second housing 310-2 among the side surface of the first housing 310-1 or the side surface of the second housing 310-2 is illustrated. The PCB 230 may be disposed adjacent to the side member 320 when viewed from the front of the electronic device 101. For example, the PCB 230 may be disposed between a border line of the side member 320 and the displaying area 330 and the side surface of the second housing 310-2.

Referring to FIG. 4A, according to an embodiment, the PCB 230 of the electronic device 101 may be disposed toward the third surface (e.g., side surface) of the second housing 310-2 different from the first housing 310-1 in which the camera 305 is disposed. In an embodiment, in an embodiment in which the first housing 310-1 and the second housing 310-2 are movably coupled, a portion of the third surface toward which the PCB 230 is directed may be a portion farthest from the first housing 310-1, among the four portions. Among the four portions of the second housing 310-2, a portion farthest from the camera 305 may be referred to as a lower surface.

Referring to FIG. 4B, a cross-sectional view of B-B' of a front view of FIG. 4A of the electronic device 101 according to an embodiment is illustrated. Referring to the cross-sectional view of FIG. 4B, the PCB 230 may be disposed between an outer surface of the first side surface 425-1 and a bent portion of the display 280, by being disposed adjacent to the first side surface 425-1 of the housing of the electronic device 101. In the first side surface 425-1, the PCB 230 may be disposed toward the outer surface of the first side surface 425-1. Although not illustrated, the electronic device 101 according to an embodiment may include a mic-hole (e.g., the mic-hole 316 of FIG. 3B) formed in at least a portion of the first side surface 425-1 toward which the PCB 230 is directed.

According to an embodiment, the PCB 230 of the electronic device 101 may be disposed toward a perforated opening of the side member 320 of the second housing 310-2. The opening may be formed in at least a portion of the first side surface 425-1 of the electronic device 101. Referring to FIG. 4B, the second housing 310-2 of the electronic device 101 may further include a member 440 capable of covering the PCB 230 disposed in the opening or filling the opening.

According to an embodiment, in an embodiment of FIG. 4B in which the PCB 230 is disposed within a lower surface of the second housing 310-2 of the electronic device 101, the FPCB 350 connected to the PCB 230 may extend from the lower surface of the second housing 310-2 to the PCB 340 disposed in an inner space of the second housing 310-2. The PCB 340 may be disposed between a portion of the display 280 and the rear surface of the second housing 310-2. On a surface of the PCB 340, a circuit (e.g., at least a portion of the communication circuit 205 including the impedance matching circuit 240 of FIG. 2) connected to the PCB 230 through the FPCB 350 may be disposed.

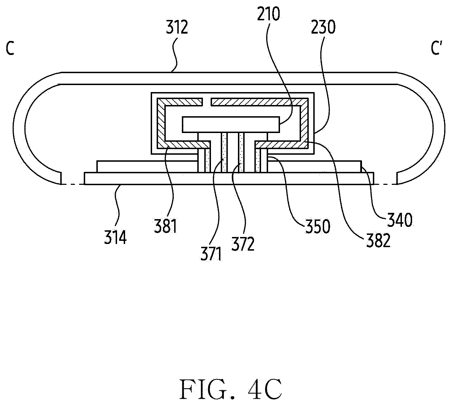

Referring to FIG. 4C, a perspective view of C-C' of the electronic device 101 of FIG. 4A is illustrated. Using a conductive pattern (e.g., conductive patterns 381 and 382) formed on the PCB 230 disposed toward the lower surface of the electronic device 101, the electronic device 101 according to an embodiment may form an antenna structure at least partially including the conductive pattern. One or more conductive lines (e.g., conductive lines 371 and 372) connected to the electronic component 210 formed on the PCB 230 may extend to the PCB 340 through the FPCB 350. For example, the antenna structure may be formed by one or more conductive patterns formed on the PCB 230. For example, the antenna structure may be formed by a conductive pattern formed on the PCB 230 and one or more conductive portions (e.g., conductive portions 312 and 314) included in the second housing 310-2 of the electronic device 101.

As described above, the electronic device 101 according to an embodiment may form an antenna structure using the PCB 230 disposed toward the side surface of the first housing 310-1 and the second housing 310-2, which are movably coupled. Since the antenna structure is formed using the PCB 230 including the electronic component 210 controlled by a processor (e.g., the processor 120 of FIG. 2), the electronic device 101 may be implemented independently of another PCB (e.g., millimeter wave module) exclusively including a patch antenna. Since a function of the other PCB is maintained while the other PCB is excluded, a degree of freedom in design of the electronic device 101 may be increased. Since the electronic device 101 includes the display 280 capable of being inserted into the second housing 310-2, a space for accommodating the display 280 may be formed in the second housing 310-2, or a driving unit assembly for deforming the display 280 may be included in the second housing 310-2. According to an embodiment, the PCB 230 of the electronic device 101 may include all of the electronic component 210 and at least one conductive pattern at least partially forming the antenna structure, in order to compensate for the limitation by a space for accommodating the driving unit assembly and the display 280.

Although an embodiment in which the first housing 310-1 and the second housing 310-2 are coupled to be slidable has been described, the embodiment is not limited thereto. In an embodiment, different portions (e.g., the first housing 310-1 and the second housing 310-2) of the housing 310 may be coupled to be foldable by a hinge assembly. In an embodiment in which the first housing 310-1 and the second housing 310-2 are coupled to be foldable, the PCB 230 may be disposed toward a portion of the side surface in the electronic device 101, similar to what is described above with reference to FIGS. 4B to 4C.

Hereinafter, different examples of at least one conductive pattern formed on the PCB 230 of the electronic device 101 according to an embodiment will be described with reference to FIGS. 5A to 5G.

FIGS. 5A to 5G are exemplary diagrams for describing a conductive pattern 510 formed on a PCB 230 included in an electronic device according to an embodiment. An electronic device of FIGS. 5A to 5G may be an example of the electronic device 101 of FIGS. 2, 3A to 3C, and/or 4A to 4C. For example, the electronic component 210 and the PCB 230 of FIGS. 2, 3A to 3C, and/or 4A to 4C may include an electronic component 210 and a PCB 230 of FIGS. 5A to 5G.

Referring to FIGS. 5A to 5G, a perspective view of a surface of the PCB 230 of the electronic device according to an embodiment is illustrated. The PCB 230 may be disposed between an edge of a displaying area (e.g., the displaying area 330 of FIGS. 3A to 3C, and/or FIGS. 4A to 4C) of a display (e.g., the display 280 of FIG. 2) of the electronic device and an edge between a front surface and a side surface of the electronic device. For example, the PCB 230 may be disposed under a side member (e.g., the side member of FIGS. 3A to 3C and/or FIGS. 4A to 4C) of the electronic device. An electronic component (e.g., the electronic component 210 of FIG. 2) electrically connected to a processor (e.g., the processor 120 of FIG. 2) such as a microphone may be disposed on the surface of the PCB 230 illustrated in FIGS. 5A to 5G. The surface of the PCB 230 may include at least one conductive pattern for forming an antenna structure (e.g., the antenna structure 220 of FIG. 2) of the electronic device. The surface of the PCB 230 may be disposed toward a side surface (e.g., a lower surface that is a portion of the side surface) of the electronic device.

Referring to FIGS. 5A to 5G, the surface of the PCB 230 may include a first edge 230a, a second edge 230b faced away from the first edge 230a, a third edge 230c extending from an end of the first edge 230a to an end of the second edge 230b, and a fourth edge 230d extending from another end of the first edge 230a to another end of the second edge 230b. For example, the first edge 230a and the second edge 230b may be spaced apart from each other in parallel, and the third edge 230c and the fourth edge 230d may be spaced apart from each other in parallel.

Referring to FIG. 5A, a surface of the PCB 230 on which a conductive pattern 510 for forming a slit antenna is formed is exemplarily illustrated. The conductive pattern 510 forming the slit antenna may be formed on a layer in the PCB 230 parallel to the surface of the PCB 230. The conductive pattern 510 of FIG. 5A may include two protruding portions 511 and 512 extending along a direction parallel to the first edge 230a of the PCB 230 and a slit 515 formed between the protruding portions. In an embodiment of FIG. 5A, the electronic component 210 may be disposed on the slit of the conductive pattern 510. In an embodiment of FIG. 5A, the conductive pattern 510 may be used as a radiator.

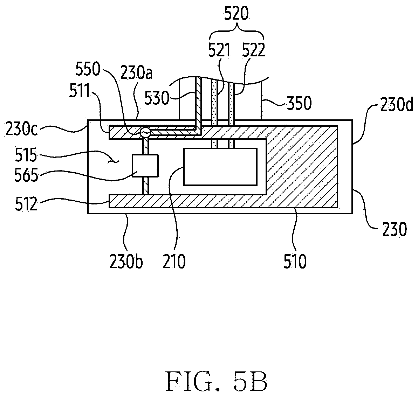

In an embodiment of FIG. 5A, the conductive pattern 510 may be grounded to form a slit antenna. A feeding point 550 related to the conductive pattern 510 of FIG. 5A may be formed spaced apart from a surface of the PCB 230 on which the conductive pattern 510 is formed. For example, among a plurality of layers of the PCB 230, the feeding point 550 may be formed on a second layer spaced apart from a first layer on which the conductive pattern 510 is formed. The feeding point 550 may be connected to the conductive line 530 extending from the FPCB 350. When the feeding point 550 is disposed on a protruding portion 511 of the conductive pattern 510, a conductive line 560 connected to the feeding point 550 and extending to another protruding portion 512 across the slit 515 may be formed on the PCB 230. Referring to FIG. 5B, instead of the conductive line 560 of FIG. 5A, an impedance device (e.g., capacitor, and/or inductor) 565 may be disposed between the feeding point 550 and the other protruding portion 512 different from the protruding portion 511 on which the feeding point 550 is disposed.

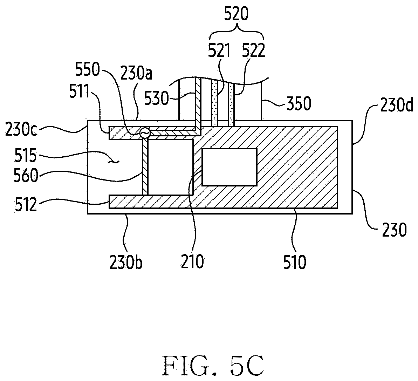

In an embodiment, the conductive pattern 510 may be disposed on another layer different from a layer of the PCB 230 on which the electronic component 210 is disposed. Referring to FIG. 5C, when looking at a surface of the PCB 230, the conductive pattern 510 disposed on the other layer may be superimposed with the electronic component 210 disposed on the layer. In an embodiment of FIG. 5C, the electronic component 210 may operate as a ground of the antenna structure.

Referring to FIG. 5D, a surface of the PCB 230 on which a conductive pattern 510 for forming an antenna structure based on a monopole antenna is formed is exemplarily illustrated. An end of the conductive pattern 510 may be connected to the conductive line 530 extending from the FPCB 350. An end of the conductive pattern 510 may be electrically connected to a feeding point. In an embodiment of FIG. 5B in which a monopole antenna is formed based on the conductive pattern 510, a length L of the conductive pattern 510 extending from the first edge 230a in contact with the FPCB 350 toward the third edge 230c and the fourth edge 230b may be formed based on a wavelength λ in a radio frequency band (e.g., L = λ/4). The FPCB 350 may include a conductive line 520 for connecting the electronic component 210 to another circuit (e.g., the processor 120 of FIG. 2), as well as a conductive line 530 connected to a feeding point of the conductive pattern 510. Referring to FIG. 5D, when the electronic component 210 is a microphone, the conductive line 520 may include a conductive line 521 connected to an anode of the microphone and a conductive line 522 connected to a cathode of the microphone.

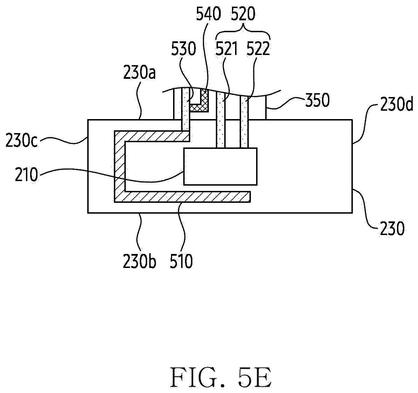

Referring to FIG. 5E, a conductive pattern 510 for forming an antenna structure based on an inverted F antenna (IFA) and conductive lines 520 and 540 connected to the conductive pattern 510 are illustrated. In order to form the IFA, a grounded conductive line 540 may be connected to a portion of the conductive line 530 electrically connected to the feeding point of the conductive pattern 510. A shape of the conductive pattern 510 of FIG. 5E may extend along edges of the PCB 230. In the IF A, the antenna length L extended from the grounding point may be determined based on the wavelength λ in the radio frequency band. Since the grounded conductive line 540 is connected on the FPCB 350, in order to transmit a wireless signal with a wavelength identical to FIG. 5D, a length of the conductive pattern 510 of FIG. 5E may be designed to be shorter than a length of the conductive pattern 510 of FIG. 5D.

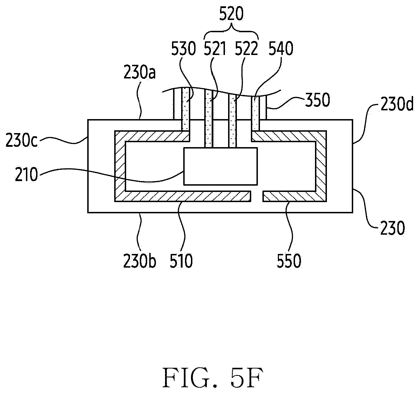

Referring to FIG. 5F, conductive patterns 510 and 550 for forming an antenna structure based on a dual IF A and conductive lines 530 and 540 connected to the conductive patterns 510 and 550 are illustrated. An end of the conductive pattern 510 connected to the conductive line 530 of FIG. 5F may be a feeding point coupled to a communication circuit (e.g., the communication circuit 205 of FIG. 2). The conductive pattern 550 of FIG. 5F may include an end connected to the grounded conductive line 540. Referring to FIG. 5F, on the FPCB 350, conductive lines 521 and 522 connected to the electronic component 210 may be disposed between the conductive lines 530 and 540.

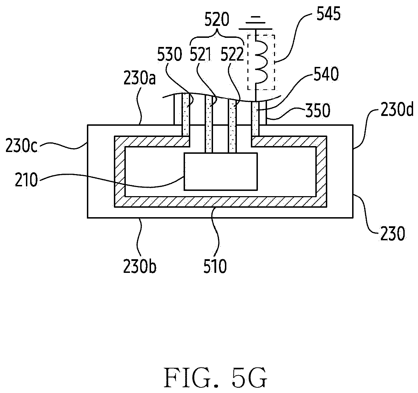

Referring to FIG. 5G, a conductive pattern 510 for forming an antenna structure based on a loop antenna and conductive lines 530 and 540 connected to both ends of the conductive pattern 510 are illustrated. An end of the conductive pattern 510 connected to the conductive line 530 of FIG. 5G may be a feeding point coupled to a communication circuit (e.g., the communication circuit 205 of FIG. 2). The conductive pattern 510 may be connected to an inductor 545 through another end of the conductive pattern 510 connected to the conductive line 540 of FIG. 5G. The inductor 545 may include an end electrically connected to the other end of the conductive pattern 510 and another grounded end.

A shape of the conductive patterns 510 and 550 exemplified in FIGS. 5D to 5G may be designed differently according to a radio frequency band or interference supported based on the antenna structure formed by the conductive patterns 510 and 550.

As described above, according to an embodiment, an antenna structure of a type selected from among different types (e.g., slit antenna, monopole antenna, IFA, dual IF A, and/or loop antenna) may be formed on the PCB 230 of the electronic device, based on one or more conductive patterns 510 and 550 formed together with the electronic component 210. The type of antenna structure may be selected based on a target resonance band and/or the PCB 230, among the types. Based on the selected type of the antenna structure, a length and/or a structure of at least one conductive pattern 510 and 550 formed on the PCB 230 may be selected.

Hereinafter, in an embodiment in which the antenna structure based on the slit antenna of FIG. 5A is formed, radiation performance and efficiency of the antenna structure will be experimentally described.

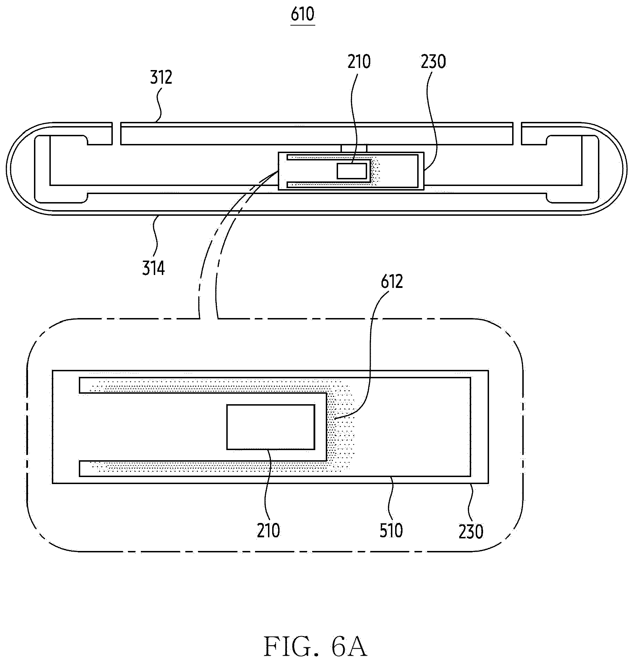

FIGS. 6A to 6C are exemplary diagrams for describing an antenna structure based on the conductive pattern 510 exemplified in FIG. 5A.

FIG. 6A is a distribution diagram 610 showing distribution of current flowing through the conductive pattern 510, in a state of looking at a lower surface of the electronic device including the conductive pattern 510 for forming the slit antenna of FIG. 5A. In an embodiment, within the slit antenna based on the conductive pattern 510, an electronic component 210, which is a microphone, may be disposed in a grounded area of the slit antenna. A driving frequency of the slit antenna may be changed based on a length of the slit formed by protruding portion of the conductive pattern 510, or impedance matching performed by an impedance matching circuit (e.g., the impedance matching circuit 240 of FIG. 2) connected to the conductive pattern 510.

Referring to FIG. 6A, the distribution of current flowing through the conductive pattern 510 while the electronic device including a PCB 230 on which the conductive pattern 510 is disposed forms a slit antenna based on the conductive pattern 510 is exemplarily illustrated. An area 612 on the conductive pattern 510 filled with dots may indicate an area through which a current flows. The area 612 being formed in the slit formed in the conductive pattern 510 may mean that the current intensively flowing in a portion of the conductive pattern 510 adjacent to the slit formed in the conductive pattern 510.

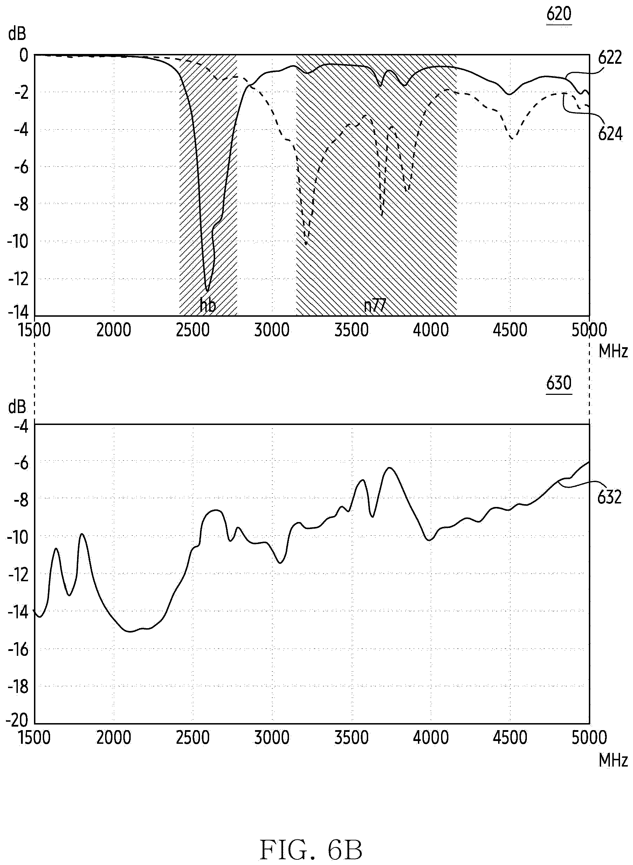

FIG. 6B is graphs 620 and 630 illustrating each of scattering parameters (e.g., S11) and radiation efficiency of the slit antenna in a frequency domain, with respect to the electronic device including the conductive pattern 510 for forming the slit antenna of FIG. 5A. Referring to graph 620, lines 622 and 624 indicate scattering parameters of each of different matching conditions for the electronic device to control the slit antenna. In a matching condition corresponding to the line 622, the slit antenna including the conductive pattern 510 may operate in a radio frequency band including 2500 MHz. In another matching condition corresponding to the line 624, the slit antenna including the conductive pattern 510 may operate in a n77 band. Referring to the line 632 of the graph 630, according to an embodiment, radiation efficiency of the slit antenna formed by the electronic device based on the conductive pattern 510 of FIG. 5A may have the radiation efficiency in a HB band. For example, scattering coefficients of each of the lines 622 and 624 may be obtained by applying different matching conditions to the slit antenna having the same radiation efficiency as the line 632.

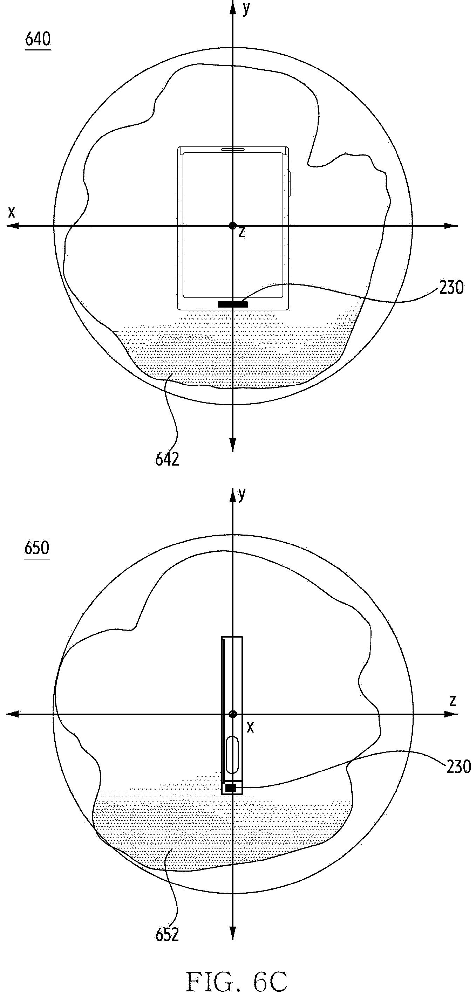

FIG. 6C is distribution diagrams 640 and 650 illustrating a radiation pattern (or antenna pattern) of a slit antenna, formed by the electronic device, based on the conductive pattern 510, in an embodiment of the electronic device including the PCB 230 on which the conductive pattern 510 of FIG. 5A is formed. Referring to the distribution diagrams 640 and 650, a gain in a peripheral space of the electronic device is illustrated based on the density of one or more dots. The gain may be proportional to the density of the one or more dots. Referring to FIG. 6C, a gain of areas 642 and 652 adjacent to the lower surface of the electronic device adjacent to the conductive pattern 510 may be higher than other areas. For example, the electronic device may radiate a wireless signal toward the lower surface of the electronic device, based on the conductive pattern 510.

FIGS. 7A to 7D are exemplary diagrams for describing an antenna structure formed by a conductive pattern 730 formed on a PCB 230 included in an electronic device and another conductive pattern included in a housing of the electronic device according to an embodiment. The electronic device of FIGS. 7A to 7D may be an example of the electronic device 101 of FIGS. 2, 3A to 3C, 4A to 4C, and/or the electronic device of FIGS. 5A to 5G. For example, the electronic component 210 and the PCB 230 of FIGS. 2, 3A to 3C, and/or 4A to 4C may include an electronic component 210 and a PCB 230 of FIGS. 7A to 7D. For example, the PCB 340 and the FPCB 350 of FIGS. 3A to 3C may include a PCB 340 and a FPCB 350 of FIGS. 7A to 7D. For example, the conductive lines 520 of FIGS. 5A to 5G may include conductive lines 520 of FIGS. 7A to 7D.

Referring to FIGS. 7A to 7D, a surface of the PCB 230 of the electronic device according to an embodiment is illustrated. In an embodiment, an electronic component 210 controlled by a processor (e.g., the processor 120 of FIG. 2) and a conductive pattern 730 at least partially forming an antenna structure may be disposed on the PCB 230. A surface of the PCB 230 may be disposed toward a side surface of a housing (e.g., the housing 310 in FIGS. 3A to 3C and/or FIGS. 4A to 4C) of the electronic device. For example, the surface of the PCB 230 may be disposed toward a lower surface of the housing.

According to an embodiment, the electronic device may form an antenna structure based on the conductive pattern 730 disposed on the PCB 230 and one or more conductive patterns (e.g., conductive portions 312 and 314) formed in the housing of the electronic device. Referring to FIGS. 7A to 7E, conductive portions 312 and 314 formed in the housing of the electronic device according to an embodiment are illustrated. The conductive portions 312 and 314 may form at least a portion of a lower surface of the housing. The conductive portions 312 and 314 may be spaced apart from each other by segmental portion 752 and 754. The PCB 230 may be disposed toward an opening 760 formed between the conductive portions 312 and 314. Although not illustrated, a member of a non-conductive material may be disposed in the opening 760 of the lower surface distinguished by the conductive portions 312 and 314. For example, the conductive portions 312 and 314 of FIGS. 3A to 3E may include conductive portions 312 and 314 of FIGS. 7A to 7D.

In the electronic device according to an embodiment, the conductive portions 312 and 314 formed in the housing may correspond to different antenna structures. For example, the electronic device may form a first antenna structure (e.g., a main 1 antenna), by applying voltage and/or current to the conductive portion 314 through a feeding point 710. For example, the electronic device may form a second antenna structure (e.g., a main 2 antenna), by applying voltage and/or current to the conductive portion 312 through a feeding point 720. The electronic device may perform wireless communication within a LMB band (e.g., a LB band, and a MB band) using the first antenna structure. The electronic device may perform wireless communication within a radio frequency band (e.g., HB band) greater than 2 GHz, using the second antenna structure.

In an embodiment, the conductive pattern 730 formed on the PCB 230 may be a parasitic pattern of the first antenna structure and/or the second antenna structure. In an embodiment in which the conductive pattern 730 is the parasitic pattern, the conductive pattern 730 may function as a radiator booster for improving radiation performance of the first antenna structure and/or the second antenna structure. For example, the electronic device may improve the radiation performance of the first antenna structure and/or the second antenna structure, by controlling a parasitic resonance using the conductive pattern 730.

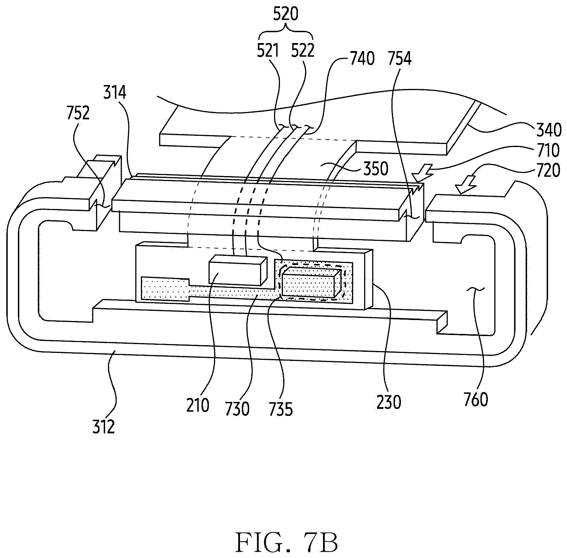

Referring to FIGS. 7A to 7D, different shapes of the conductive pattern 730 for functioning as a parasitic pattern related to the first antenna structure and/or the second antenna structure are illustrated. Referring to FIG. 7A, the conductive pattern 730 may be electrically separated from a communication circuit (e.g., the communication circuit 205 of FIG. 2) of the electronic device. Referring to FIGS. 7B to 7D, the conductive pattern 730 may be grounded based on the conductive line 740. For example, the conductive line 740 included in the FPCB 350 and extended to the PCB 340 may be connected to a node (e.g., a ground node) disposed on the PCB 340.

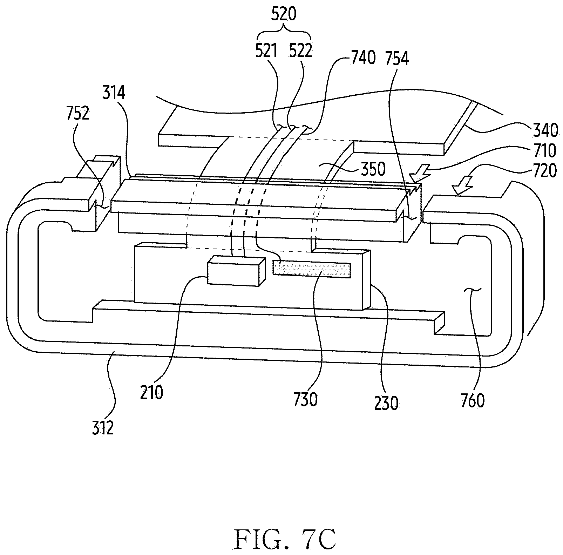

Referring to FIG. 7B, the conductive pattern 730 of the electronic device may include a protruding portion 735 for increasing a coupling area between the conductive portions 312 and 314 and the conductive pattern 730. Based on the protruding portion 735, an area where the conductive portions 312 and 314 and the conductive pattern 730 are adjacent may increase. Referring to FIGS. 7C to 7D, different shapes of the conductive pattern 730 grounded by the conductive line 740 are illustrated. A shape of the conductive pattern 730 may be designed differently according to embodiments, in order to control parasitic resonance based on the conductive pattern 730.

As described above, according to an embodiment, at least one conductive pattern (e.g., conductive pattern 730) formed on the PCB 230 of the electronic device may form an antenna structure together with at least one other conductive pattern (e.g., conductive parts 312 and 314) formed in the housing of the electronic device adj acent to the PCB 230. The at least one conductive pattern formed on the PCB 230 may have a shape suitable for controlling parasitic resonance of the antenna structure or functioning as a radiator booster based on a parasitic pattern. As another example, the conductive pattern 730 may or may not be electrically connected to the ground based on a resonance frequency of the antenna structure.

Although an embodiment in which a single conductive pattern 730 is disposed on the PCB 230 has been described, the embodiment is not limited thereto. In an embodiment, a plurality of conductive patterns may be formed on the PCB 230 of the electronic device. The plurality of conductive patterns may be disposed on the PCB 230, in order to control the parasitic resonance of the antenna structure formed by conductive portions (e.g., conductive portions 312 and 314) included in the housing of the electronic device.

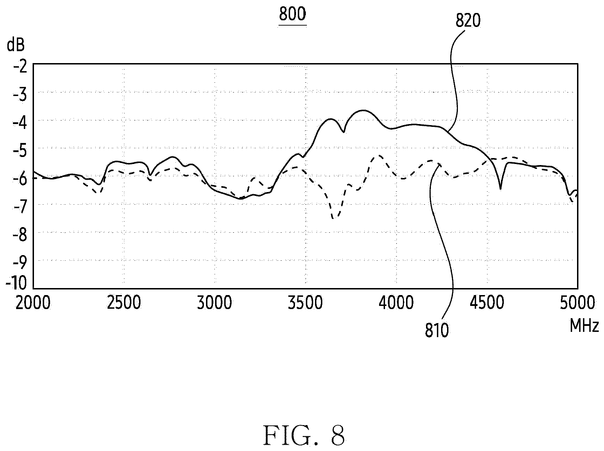

Hereinafter, referring to FIG. 8, in an embodiment in which an antenna structure based on the conductive pattern 730 and the conductive portions 312 and 314 of FIG. 7C is formed, the radiation performance of the antenna structure will be experimentally described.

FIG. 8 is an exemplary diagram for describing an antenna structure based on the conductive pattern exemplified in FIG. 7C.

The graph 800 of FIG. 8 illustrates a line 820 illustrating radiation efficiency in a state that an electronic device including the conductive pattern 730 of FIG. 7C feeds the feeding point 720 and forms a parasitic pattern using the conductive pattern 730, and a line 810 illustrating radiation efficiency of another electronic device in which the conductive pattern 730 and/or the parasitic pattern is not formed. Referring to the lines 810 and 820, the radiation efficiency of the electronic device in which the parasitic pattern is formed using the conductive pattern 730 may be improved within the n77 band.

According to an embodiment, a length and a position of the conductive pattern 730 of the electronic device may be designed to improve the radiation performance in a specific frequency band based on the conductive pattern 730, which is a parasitic pattern. An embodiment for improving the radiation performance in the n77 band as shown in the line 820 of FIG. 8 has been described, but the embodiment is not limited thereto. For example, the conductive pattern 730 of the electronic device may have a form for improving radiation performance in another radio frequency band (e.g., LB band, MB band, Sub-6 band, and/or UWB band) different from the n77 band.

As described above, one or more conductive patterns for at least partially forming an antenna structure and the electronic component 210 may be formed or integrated on the PCB 230 of the electronic device according to an embodiment. In order to be integrated with the one or more conductive patterns, on the PCB 230, the electronic device according to an embodiment may further include a circuit for reducing interference with the electronic component 210 and the antenna structure formed by the one or more conductive patterns. Hereinafter, an example of a circuit for reducing interference with the antenna structure by being connected to the electronic component 210 of the electronic device according to an embodiment will be described with reference to FIG. 9.

FIG. 9 is a diagram for describing an example of a circuit including an electronic component 210 included in a PCB 230 of an electronic device according to an embodiment. The electronic device of FIG. 9 may be an example of the electronic device of FIGS. 2, 3A to 3C, 4A to 4C, 5A to 5G, and/or 7A to 7D. For example, the electronic device 101 and the electronic component 210 of FIGS. 2, 3A to 3C, 4A to 4C may include a PCB 230 and an electronic component 210 of FIG. 9. For example, the PCB 340 and the FPCB 350 of FIGS. 3A to 3C may include a PCB 340 and a FPCB 350 of FIG. 9. For example, the conductive line 520 of FIGS. 5A to 5G may include a conductive line 520 of FIG. 9. Although an embodiment including the conductive pattern 510 and conductive lines 530 and 540 connected to the conductive pattern 510 of FIG. 5E is illustrated, the embodiment is not limited thereto.

According to an embodiment, the electronic component 210 disposed on a surface of the PCB 230 may include a microphone. In an embodiment in which the electronic component 210 includes a microphone, the conductive line 520 may include at least two conductive lines 521 and 522. For example, the conductive line 521 may be connected to the anode of the microphone and the conductive line 522 may be connected to the cathode of the microphone. According to an embodiment, the electronic device may include an inductor 910 for reducing interference between the conductive line 520 extending from the electronic component 210 and another conductive line (e.g., a conductive line extending from the conductive pattern 510, such as conductive lines 530 and 540). Referring to FIG. 9, according to an embodiment, the electronic device may include conductive lines 521 and 522 connected to the electronic component 210 and inductors 911 and 912 connected to each of the conductive lines 521 and 522 to reduce interference between the conductive lines 530 and 540 connected to the conductive pattern 510. The inductance of the inductors 911 and 912 may have inductance (e.g., 100 nH) for reducing interference in a radio frequency band. Referring to FIG. 9, each of the inductors 911 and 912 may include an end connected to a portion of the conductive lines 521 and 522 and another grounded end.

As described above, according to an embodiment, the electronic device may form an antenna structure based on the PCB 230 disposed toward a portion (e.g., a lower surface) of a side surface of a housing. For example, the PCB 230 may be disposed toward an opening penetrating conductive patterns disposed on the lower surface of the housing. According to an embodiment, insulator may be filled in the opening. The antenna structure may include a conductive pattern disposed on a surface of the PCB 230 directing the lower surface. The conductive pattern may be, when looking at the opening, at least partially superimposed on the opening. In an embodiment, the conductive pattern and an electronic component operably coupled with a processor of the electronic device may be integrated on the surface of the PCB 230. The electronic component may include hardware (e.g., microphone) for supporting a function different from wireless communication based on the antenna structure.

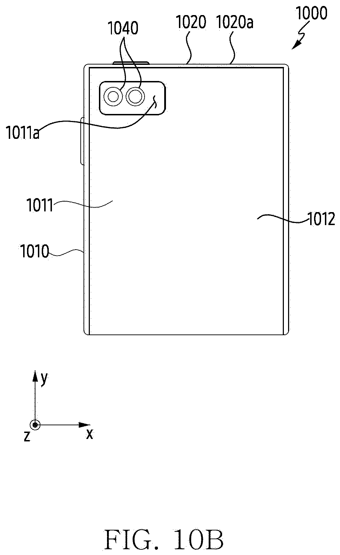

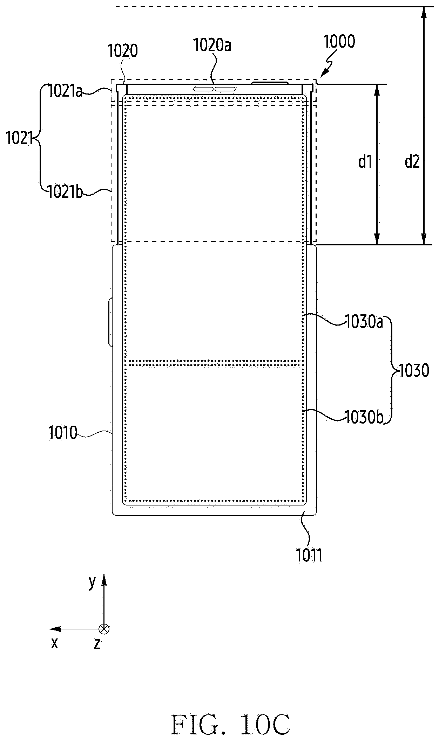

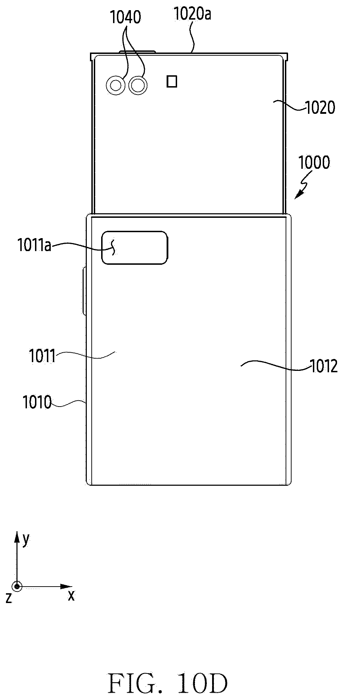

FIG. 10A is a front view of a first state of an electronic device according to an embodiment, FIG. 10B is a rear view of a first state of an electronic device according to an embodiment, FIG. 10C is a front view of a second state of an electronic device according to an embodiment, and FIG. 10D is a rear view of a second state of an electronic device according to an embodiment.

Referring to FIGS. 10A, 10B, 10C, and 10D, an electronic device 1000 (e.g., the electronic device 101 of FIGS. 1 to 3) according to an embodiment may include a second housing 1010, a first housing 1020, a display 1030 (e.g., the display module 110 of FIG. 1), and a camera 1040 (e.g., the camera module 180 of FIG. 1). According to an embodiment, the first housing 1020 may be slidable with respect to the second housing 1010. For example, the first housing 1020 may move in a range within a specified distance with respect to the second housing 1010 along a first direction (e.g., +y direction). When the first housing 1020 moves in the first direction, a distance between a side surface 1020a of the first housing 1020 directing the first direction and the second housing 1010 may increase. For another example, the first housing 1020 may move in a range within a specified distance with respect to the second housing 1010 along a second direction (e.g., -y direction) opposite to the first direction. When the first housing 1020 moves along the second direction, a distance between the side surface 1020a of the first housing 1020 directing the first direction and the second housing 1010 may decrease. According to an embodiment, the first housing 1020 may linearly reciprocate with respect to the second housing 1010 by sliding relatively with respect to the second housing 1010. For example, at least a portion of the first housing 1020 may be inserted into the second housing 1010 or extracted from the second housing 1010.

According to an embodiment, as the first housing 1020 is designed to be slidable with respect to the second housing 1010, the electronic device 1000 may be referred to as a "slidable electronic device". According to an embodiment, as at least a portion of the display 1030 is designed to be wound inside the first housing 1020 (or the second housing 1010) based on slide movement of the first housing 1020, the electronic device 1000 may be referred to as a "rollable electronic device".

According to an embodiment, a first state of the electronic device 1000 may be defined as a state in which the first housing 1020 moves in the second direction (e.g., a contracted state or a slide-in state). For example, in the first state of the electronic device 1000, the first housing 1020 may be movable in the first direction, but may not be movable in the second direction. In the first state of the electronic device 1000, as the first housing 1020 moves, a distance between the side surface 1020a of the first housing 1020 and the second housing 1010 may increase, but may not decrease. For another example, in the first state of the electronic device 1000, a portion of the first housing 1020 may be extracted from the second housing 1010, but may not be inserted into the second housing 1010. According to an embodiment, the first state of the electronic device 1000 may be defined as a state in which a second area 1030b of the display 1030 is not visually exposed outside the electronic device 1000. For example, in the first state of the electronic device 1000, the second area 1030b of the display 1030 may be located inside an inner space (not illustrated) of the electronic device 1000 formed by the second housing 1010 and/or the first housing 1020, and may not be visible from the outside of the electronic device 1000.

According to an embodiment, the second state of the electronic device 1000 may be defined as a state in which the first housing 1020 moves in the first direction (e.g., an expanded state or a slide-out state). For example, in the second state of the electronic device 1000, the first housing 1020 may be movable in the second direction, but may not be movable in the first direction. In the second state of the electronic device 1000, as the first housing 1020 moves, the distance between the side surface 1020a of the first housing 1020 and the second housing 1010 may decrease, but may not increase. For another example, in the second state of the electronic device 1000, a portion of the first housing 1020 may be inserted into the second housing 1010, but may not be extracted from the second housing 1010. According to an embodiment, the second state of the electronic device 1000 may be defined as a state in which the second area 1030b of the display 1030 is visually exposed from the outside of the electronic device 1000. For example, in the second state of the electronic device 1000, the second area 1030b of the display 1030 may be extracted from the inner space of the electronic device 1000, and visible from the outside of the electronic device 1000.

According to an embodiment, when the first housing 1020 moves from the second housing 1010 in the first direction, at least a portion of the first housing 1020 and/or the second area 1030b of the display 1030 may be extracted from the second housing 1010 by an extraction length d1 corresponding to a moving distance of the first housing 1020. According to an embodiment, the first housing 1020 may reciprocate within a specified distance d2. According to an embodiment, the extraction length d1 may have a size of about 0 to the specified distance d2.

According to an embodiment, a state of the electronic device 1000 may be convertible between the second state and/or the first state, by a manual operation by a user or an automatic operation by a driving module (not illustrated) disposed inside the second housing 1010 or the first housing 1020. According to an embodiment, an operation of the driving module may be triggered based on a user input. According to an embodiment, the user input for triggering the operation of the driving module may include a touch input, a force touch input, and/or a gesture input through the display 1030. According to another embodiment, the user input for triggering the operation of the driving module may include a sound input (voice input) or an input of a physical button exposed to the outside of the second housing 1010 or the first housing 1020. According to an embodiment, the driving module may be driven in a semi-automatic manner in which an operation is triggered when a manual operation by an external force of a user is detected.

According to an embodiment, the first state of the electronic device 1000 may be referred to as a first shape, and the second state of the electronic device 1000 may be referred to as a second shape. For example, the first shape may include a normal state, a reduced state, or a closed state, and the second shape may include an opened state. According to an embodiment, the electronic device 1000 may form a third state (e.g., an intermediate state), which is a state between the first state and the second state. For example, the third state may be referred to as a third shape, and the third shape may include a free-stop state.

According to an embodiment, the display 1030 may be visible (or viewable) from the outside through a front direction (e.g., -z direction) of the electronic device 1000 to display visual information to the user. For example, the display 1030 may include a flexible display. According to an embodiment, the display 1030 may be disposed in the first housing 1020, and may be extracted from an inner space (not illustrated) of the electronic device 1000 or may be inserted into the inner space of the electronic device 1000 according to the movement of the first housing 1020. The inner space of the electronic device 1000 may mean a space within the second housing 1010 and the first housing 1020, formed by a coupling of the second housing 1010 and the first housing 1020. For example, in the first state of the electronic device 1000, at least a portion of the display 1030 may be rolled into and inserted into the inner space of the electronic device 1000. When the first housing 1020 moves in the first direction in a state that at least a portion of the display 1030 is inserted into the inner space of the electronic device 1000, at least a portion of the display 1030 may be extracted from the inner space of the electronic device 1000. For another example, when the first housing 1020 moves in the second direction, at least a portion of the display 1030 may be inserted into the inner space of the electronic device 1000 by being rolled inside the electronic device 1000. As at least a portion of the display 1030 is extracted or inserted, an area of the display 1030 visible from the outside of the electronic device 1000 may be expanded or reduced. According to an embodiment, the display 1030 may include a first area 1030a and a second area 1030b.

According to an embodiment, the first area 1030a of the display 1030 may mean an area of the display 1030 fixedly visible from the outside of the electronic device 1000, regardless of whether the electronic device 1000 is in the second state or the first state. For example, the first area 1030a may mean a partial area of the display 1030 not rolled into the inner space of the electronic device 1000. According to an embodiment, when the first housing 1020 moves, the first area 1030a may move together with the first housing 1020. For example, when the first housing 1020 moves along the first direction or the second direction, the first area 1030a may move along the first direction or the second direction on the front of the electronic device 1000, together with the first housing 1020.

According to an embodiment, the second area 1030b of the display 1030 may be connected to the first area 1030a, and may be introduced into the inner space of the electronic device 1000 or extracted from the inner space of the electronic device 1000 according to the movement of the first housing 1020. For example, the second area 1030b of the display 1030 may be a state of being inserted into the inner space of the electronic device 1000 with a rolled state, in the first state of the electronic device 1000. The second area 1030b of the display 1030 may be inserted into the inner space of the electronic device 1000 in the first state of the electronic device 1000 and may not be visible from the outside. For another example, the second area 1030b of the display 1030 may be a state of being extracted from the inner space of the electronic device 1000 in the second state of the electronic device 1000. The second area 1030b of the display 1030 may be visible from the outside of the electronic device 1000 in the second state.

According to an embodiment, in the first state of the electronic device 1000, an area of the display 1030 visible from the outside of the electronic device 1000 may include only the first area 1030a of the display 1030. In the second state of the electronic device 1000, the area of the display 1030 visible from the outside of the electronic device 1000 may include at least a portion of the first area 1030a and the second area 1030b of the display 1030.

According to an embodiment, the second housing 1010 of the electronic device 1000 may include a book cover 1011 surrounding the inner space of the second housing 1010 and a rear plate 1012 surrounding a rear surface of the book cover 1011. The first housing 1020 of the electronic device 1000 may include a front cover 1021 surrounding the inner space of the electronic device 1000.

According to an embodiment, the front cover 1021 may include a first cover area 1021a of the front cover 1021 not inserted into the inside of the second housing 1010 and a second cover area 1021b inserted into or extracted from the inside of the second housing 1010. The first cover area 1021a of the front cover 1021 may always visible, regardless of whether the electronic device 1000 is in the second state and the first state. According to an embodiment, at least a portion of the first cover area 1021a of the front cover 1021 may form the side surface 1020a of the first housing 1020. According to an embodiment, the second cover area 1021b of the first housing 1020 may not be visible in the first state, but may be visible in the second state.

The camera 1040 may obtain an image of a subject, based on receiving light from the outside of the electronic device 1000. According to an embodiment, the camera 1040 may include one or more lenses, an image sensor, and/or an image signal processor. According to an embodiment, the camera 1040 may be disposed on the first housing 1020 to face the rear surface of the electronic device 1000 opposite to the front surface of the electronic device 1000 on which the first area 1030a of the display 1030 is disposed. For example, the camera 1040 may be disposed on the front cover 1021 of the first housing 1020, and when the electronic device 1000 is in the first state, it may be visible from the outside of the electronic device 1000 through an opening 1011a formed in the book cover 1011. For another example, the camera 1040 may be disposed on the front cover 1021 of the first housing 1020 and when the electronic device 1000 is in the first state, it may be invisible from the outside of the electronic device 1000 by being covered by the book cover 1011 and/or the rear plate 1012.

According to an embodiment, the camera 1040 may include a plurality of cameras. For example, the camera 1040 may include a wide-angle camera, an ultra-wide-angle camera, a telephoto camera, a proximity camera, and/or a depth camera. However, the camera 1040 is not necessarily limited to including a plurality of cameras, and may include a single camera.

According to an embodiment, the camera 1040 may further include a camera (not illustrated) facing the front of the electronic device 1000 on which the first area 1030a of the display 1030 is disposed. When the camera 1040 faces the front of the electronic device 1000, the camera 1040 may be an under display camera (UDC) disposed below the display 1030 (e.g., in the +z direction from the display 1030), but is not limited thereto.

According to an embodiment, the electronic device 1000 may include a sensor module (not illustrated) and/or a camera module (not illustrated) disposed below the display 1030. The sensor module may detect an external environment based on information (e.g., light) received through the display 1030. According to an embodiment, the sensor module may include at least one of a receiver, a proximity sensor, an ultrasonic sensor, a gesture sensor, a gyro sensor, a barometric sensor, a magnetic sensor, an acceleration sensor, a grip sensor, a color sensor, an infrared (IR) sensor, a biometric sensor, a temperature sensor, a humidity sensor, a motor encoder, or an indicator. According to an embodiment, at least some sensor module of the electronic device 1000 may be visually exposed from the outside through a partial area of the display 1030. According to an embodiment, the electronic device 1000 may detect an extraction length (e.g., length A) using the sensor module. According to an embodiment, the electronic device 1000 may generate extraction information on a degree of extraction detected by the sensor. For example, the electronic device 1000 may detect and/or check the degree of extraction of the first housing 1020 using the extraction information. According to an embodiment, the extraction information may include information on the extraction length of the first housing 1020.

According to an embodiment, a coupling shape of the second housing 1010 and the first housing 1020 is not limited to shapes and coupling illustrated in FIGS. 10A, 10B, 10C, and 10D, and may be implemented by a combination and/or coupling of other shapes or components.

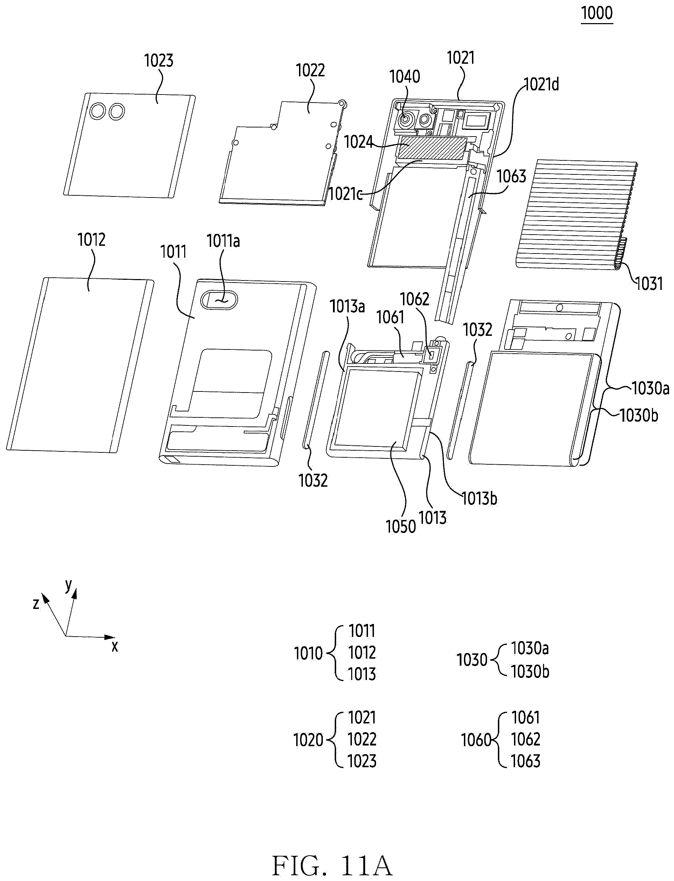

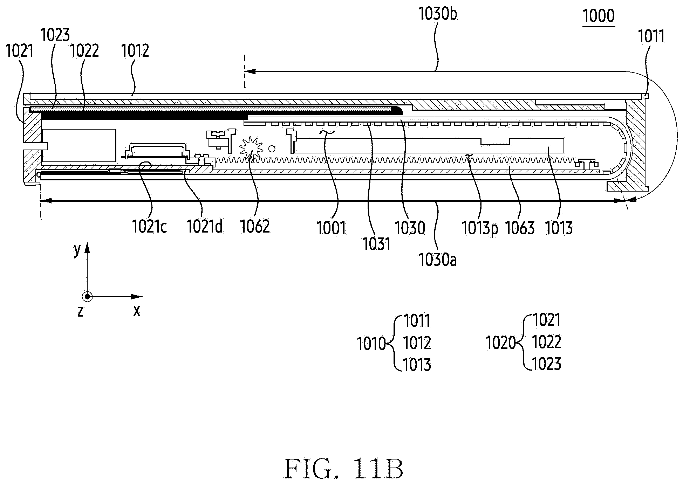

FIG. 11A is an exploded perspective view of an electronic device according to an embodiment, and FIG. 11B is a cross-sectional view illustrating an example of an electronic device according to an embodiment, cut along line A-A' of FIG. 15A.

Referring to FIGS. 11A and 11B, an electronic device 1000 according to an embodiment may include a second housing 1010, a first housing 1020, a display 1030, a camera 1040, a battery 1050 (e.g., a battery 189 of FIG. 1), and a driving unit 1060. According to an embodiment, the second housing 1010 and the first housing 1020 may be coupled to each other and form an inner space 1001 of the electronic device 1000. For example, in a first state of the electronic device 1000, a second area 1030b of the display 1030 may be accommodated in the inner space 1001.

According to an embodiment, the second housing 1010 may include a book cover 1011, a rear plate 1012, and a frame cover 1013. According to an embodiment, the book cover 1011, the rear plate 1012, and the frame cover 1013 included in the second housing 1010 may be coupled to each other and may not move when the first housing 1020 moves with respect to the second housing 1010. According to an embodiment, the book cover 1011 may form at least a portion of an outer surface of the electronic device 1000. For example, the book cover 1011 may form at least a portion of a side surface of the electronic device 1000 and may form at least a portion of a rear surface of the electronic device 1000. According to an embodiment, the rear plate 1012 may provide a surface on which the rear plate 1012 is mounted. The rear plate 1012 may be mounted on a surface of the book cover 1011.

According to an embodiment, the frame cover 1013 may support internal components of the electronic device 1000. For example, the frame cover 1013 may accommodate at least a portion of the battery 1050 and the driving unit 1060. The battery 1050 and the driving unit 1060 may be accommodated in at least one of a recess or a hole included in the frame cover 1013. According to an embodiment, the frame cover 1013 may be surrounded by the book cover 1011. For example, in the first state of the electronic device 1000, a surface 1013a of the frame cover 1013 on which the battery 1050 is disposed may face the book cover 1011 and/or the second area 1030b of the display 1030. For another example, in the first state of the electronic device 1000, another surface 1013b of the frame cover 1013 facing the surface 1013a of the frame cover 1013 may face the first area 1030a of the display 1030, or a front cover 1021. For example, the frame cover 1013 may include aluminum as a material, but is not limited thereto.

According to an embodiment, the first housing 1020 may include a front cover 1021, a rear cover 1022, and a slide cover 1023. According to an embodiment, the front cover 1021, the rear cover 1022, and the slide cover 1023 may be coupled with each other, and move together with the first housing 1020 when the first housing 1020 moves relative to the second housing 1010. The front cover 1021 may support internal components of the electronic device 1000. For example, a printed circuit board 1024 on which electronic components (e.g., the processor 120 of FIG. 1) of the electronic device 1000 are disposed and/or the camera 1040 may be disposed on a surface 1021c of the front cover 1021 facing the inner space 1001. Another surface 1021d of the front cover 1021 facing the surface 1021c of the front cover 1021 may face the first area 1030a of the display 1030 when the electronic device 1000 is in the first state. According to an embodiment, the rear cover 1022 may be coupled to the front cover 1021 to protect components of the electronic device 1000 disposed on the front cover 1021. For example, the rear cover 1022 may cover a portion of the surface 1021c of the front cover 1021. According to an embodiment, the slide cover 1023 may be disposed on the rear cover 1022 to form an outer surface of the electronic device 1000 together with the rear plate 1012 and the book cover 1011. The slide cover 1023 may be coupled to a surface of the rear cover 1022 to protect the rear cover 1022 and/or the front cover 1021.

According to an embodiment, when the electronic device 1000 is in the first state, the display 1030 may be bent by being rolled at least partially into the inner space 1001. According to an embodiment, the display 1030 may cover at least a portion of the frame cover 1013 and at least a portion of the front cover 1021. For example, when the electronic device 1000 is in the first state, the display 1030 may cover the other surface 1021d of the front cover 1021 and extend toward the inner space 1001 by passing between the front cover 1021 and the book cover 1011. The display 1030 may pass between the front cover 1021 and the book cover 1011 and then surround the frame cover 1013. The display 1030 may cover a surface 1013a of the frame cover 1013 within the inner space 1001. According to an embodiment, when the first housing 1020 moves in the first direction, the second area 1030b of the display 1030 may be extracted from the inner space 1001. For example, as the first housing 1020 moves in the second direction, the display 1030 may pass between the front cover 1021 and the book cover 1011 and be extracted from the inner space 1001.

According to an embodiment, the electronic device 1000 may include a support bar 1031 supporting the display 1030 and a guide rail 1032. For example, the support bar 1031 may include a plurality of bars coupled to each other and may be manufactured in a shape corresponding to the shape of the second area 1030b of the display 1030. According to an embodiment, as the display 1030 moves, the support bar 1031 may move together with the display 1030. According to an embodiment, in the first state in which the second area 1030b of the display 1030 is wound in the inner space 1001, the support bar 1031 may be wound in the inner space 1001 together with the second area 1030b of the display 1030. As the first housing 1020 moves in the first direction, the support bar 1031 may move together with the second area 1030b of the display 1030. According to an embodiment, the guide rail 1032 may guide movement of the support bar 1031. For example, as the display 1030 moves, the support bar 1031 may move along the guide rail 1032 coupled to the frame cover 1013. According to an embodiment, the guide rail 1032 may be coupled to the frame cover 1013. For example, the guide rail 1032 may include a plurality of guide rails 1032 spaced apart and disposed at both edges of the frame cover 1013, wherein both edges of the frame cover 1013 are spaced apart from each other along a third direction (e.g., +x direction) perpendicular to the first direction.

According to an embodiment, the driving unit 1060 may provide a driving force to the first housing 1020 so that the first housing 1020 may move relative to the second housing 1010. According to an embodiment, the driving unit 1060 may include a motor 1061, a pinion gear 1062, and a rack gear 1063. The motor 1061 may receive power from the battery 1050 and provide driving power to the first housing 1020. According to an embodiment, the motor 1061 may be disposed in the second housing 1010 and may not move when the first housing 1020 moves with respect to the second housing 1010. For example, the motor 1061 may be disposed in a recess formed in the frame cover 1013. According to an embodiment, the pinion gear 1062 may be coupled to the motor 1061 and may rotate by a driving force provided from the motor 1061. According to an embodiment, the rack gear 1063 may be engaged with the pinion gear 1062 and move according to the rotation of the pinion gear 1062. For example, the rack gear 1063 may linearly reciprocate in the first direction or the second direction according to the rotation of the pinion gear 1062. According to an embodiment, the rack gear 1063 may be disposed in the first housing 1020. For example, the rack gear 1063 may be coupled to the front cover 1021 included in the first housing 1020. According to an embodiment, the rack gear 1063 may be movable inside an operating space 1013p formed in the frame cover 1013.

According to an embodiment, when the pinion gear 1062 rotates along a first rotation direction (e.g., clockwise in FIG. 11B), the rack gear 1063 may move in a first direction (e.g., +y direction). When the rack gear 1063 moves along the first direction, the first housing 1020 coupled to the rack gear 1063 may move along the first direction. As the first housing 1020 moves along the first direction, an area of the display 1030 visible from the outside of the electronic device 1000 may be expanded. When the pinion gear 1062 rotates along a second rotation direction (e.g., counterclockwise in FIG. 11B), the rack gear 1063 may move in a second direction (e.g., -y direction). When the rack gear 1063 moves along the second direction, the first housing 1020 coupled to the rack gear 1063 may move along the second direction. As the first housing 1020 moves along the second direction, an area of the display 1030 visible from the outside of the electronic device 1000 may be reduced.

In the above description, it has been described that the motor 1061 and the pinion gear 1062 are disposed in the second housing 1010, and the rack gear 1063 is disposed in the first housing 1020, but embodiments may not be limited thereto. According to embodiments, the motor 1061 and the pinion gear 1062 may be disposed in the first housing 1020, and the rack gear 1063 may be disposed in the second housing 1010.

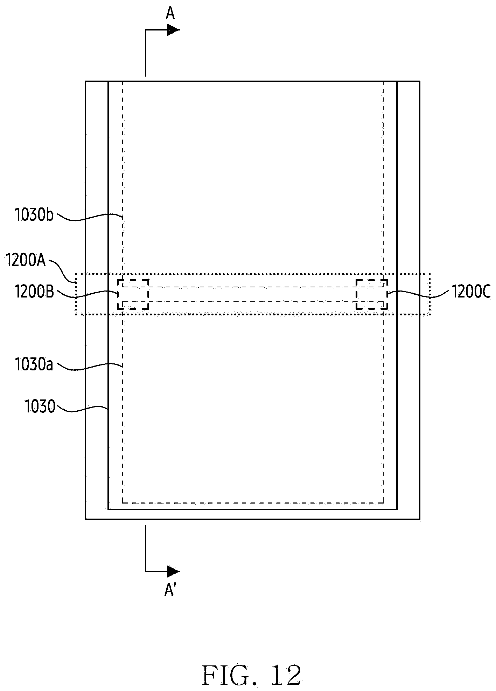

FIG. 12 is a front view of a second state indicating a boundary portion of a display of an electronic device according to an embodiment.

Referring to FIG. 12, a display 1030 of an electronic device 1000 may include a first area 1030a and a second area 1030b. The display 1030 may be referred to as a flexible display device deformable according to a state of the electronic device 1000. The first area 1030a of the display 1030 may mean an area of the display 1030 visible from the outside of the electronic device 1000, regardless of the state of the electronic device 1000. The first area 1030a may mean a partial area of the display 1030 not rolled into an inner space of the electronic device 1000. Since the first area 1030a always maintains a flat surface, it may be referred to as a flat area.

According to an embodiment, the second area 1030b of the display 1030 may extend from the first area 1030a, and may be inserted into the inner space of the electronic device 1000 or extracted from the inner space of the electronic device 1000 to the outside according to the movement of a first housing 1020 (e.g., the first housing 1020 of FIG. 10A). According to a state of the electronic device 1000, the second area 1030b may include an area forming a plane with the first area 1030a, and may be rolled into the first housing 1020. Since the second area 1030b is changed to a plane or a curved surface according to a state of the electronic device, it may be referred to as a deformation area.

According to an embodiment, the display 1030 may include different structures in a boundary portion 1200a of the first area 1030a and the second area 1030b. For example, the first area 1030a always maintains a plane, so a support portion supporting the first area 1030a of the display 1030 may have a structure not deformed. Since the second area 1030b is deformed according to a state of the electronic device 1000, a support portion supporting the second area 1030b of the display 1030 may have a deformable structure.

According to an embodiment, in the boundary portion 1200A of the display 1030, a step difference may be generated according to different structures of the first area 230a and the second area 230b, or the boundary portion 1200A may be visible by a difference in reflectance. A structure of the electronic device 1000 or the display 1030 capable of reducing visibility of the boundary portion 1200A will be described in detail with reference to FIGS. 6A to 10.

According to an embodiment, a structure for preventing visibility of the boundary portion 1200A of the display 1030 may be formed on both end portions 1200B and 1700C of the boundary portion 1200A. The display 1030 may include an active area for transmitting visual information to the outside and/or an inactive area in which a pixel is not disposed or a dummy pattern that is not driven exists. The structure formed in both end portions 1200B and 1700C may be disposed in the inactive area of the display 1030, and may not be visible to the outside, regardless of the driving of the display 1030.

An electronic device including a slidable structure may lack a space for arrange an antenna due to a factor such as a driving unit or a structure to support sliding. According to various embodiments of the present invention, an electronic device may support a wireless communication function using a PCB disposed adjacent to a surface of a housing of the electronic device and including an electronic component for supporting a designated function. The electronic component, and a conductive pattern for supporting the wireless communication function may be disposed on a surface of the PCB facing the surface of the housing.

As described above, an electronic device (e.g., the electronic device 101 of FIGS. 1 to 2) includes a housing (e.g., the housing 310 of FIGS. 3A to 3C, and/or FIGS. 4A to 4C), which includes a first surface, a second surface facing away from the first surface, and a third surface disposed between the first surface and the second surface. The electronic device includes a display (e.g., the display 280 of FIG. 2) disposed on the first surface of the housing. The electronic device includes a processor (e.g., the processor 120 of FIG. 2) for displaying an image on the display. The electronic device includes communication circuitry (e.g., the communication circuit 205 of FIG. 2) connected to the processor. The electronic device includes a PCB (e.g., the PCB 230 of FIG. 2) including an electronic component (e.g., the electronic component 210 of FIG. 2) connected to the processor independently of the impedance matching circuit, and disposed on a surface directed toward the third surface. The PCB of the electronic device includes a conductive pattern (e.g., the conductive pattern 510 of FIGS. 5A to 5G and/or FIGS. 7A to 7E) formed on a surface of the PCB directed toward the third surface and coupled to a feeding line extending from the communication circuitry. The PCB of the electronic device may be disposed adjacent to the third surface. The PCB of the electronic device may be disposed between an edge between the third surface and the first surface and an edge of a displaying area (e.g., the displaying area 330 of FIGS. 3A to 3C and/or 4A to 4C) on the first surface where the display is exposed outside.

According to an embodiment, an electronic device may emit a wireless signal using a conductive pattern for performing a wireless communication function and a PCB in which an electronic component for performing a designated function is integrated. According to an embodiment, the electronic device may support the wireless communication function using a PCB disposed adjacent to a surface of the housing of the electronic device and including an electronic component for supporting a function different from the wireless communication function.

For example, the display may include an area insertable into the housing. The PCB may be disposed between the area and the third surface in a state in which the area of the display is inserted into the housing.

For example, the electronic device may further include another PCB facing the first surface. The electronic device may further include an impedance matching circuit disposed on the other PCB and connected to the conductive pattern to perform impedance matching of the antenna structure.

For example, the conductive pattern may include a first protruding portion including a feeding point coupled to the feeding line and a second protruding portion facing away from the first protruding portion.

For example, the electronic device may further include another conductive line including an end connected to a grounding point included in the second protruding portion and another end that is grounded.

For example, the conductive pattern may form a slit antenna for transmitting or receiving a wireless signal using a slit formed between the first protruding portion and the second protruding portion.

For example, the conductive pattern may extended from an end of the conductive pattern, which is a feeding point coupled to the feeding line, along one or more edges of the surface of the PCB.

For example, the surface of the PCB may include a first edge, a second edge parallel to the first edge, a third edge extended from an end of the first edge to an end of the second edge, and a fourth edge extended from another end of the first edge to another end of the second edge and parallel to the third edge. The conductive pattern may be a first conductive pattern extending along a first portion including an end of the first edge, the third edge, and a second portion including an end of the second edge.

For example, the PCB may further include a second conductive pattern formed on the surface of the PCB, and extending along a third portion of the first edge different from the first portion and including another end of the first edge, the fourth edge, and a fourth portion different from the second portion and including another end of the second edge. An end of the second conductive pattern included in the third portion may be grounded.

For example, the electronic device may further include a conductive line including an end coupled to a portion of the feeding line and another end that is grounded.

For example, the electronic device may further include an inductor including an end connected to another end of the conductive pattern and another end that is grounded.

For example, the electronic component may include a microphone disposed toward a mic-hole formed on the third surface and configured to receiving an acoustic signal.

For example, the electronic device may further include a first conductive line for transmitting an electric signal transmitted from an anode of the microphone to the processor. The electronic device may further include a first inductor including an end connected to the first conductive line and another end that is grounded. The electronic device may further include a second conductive line connected to a cathode of the microphone. The electronic device may further include a second inductor including an end connected to the second conductive line and another end that is grounded.

For example, the electronic device may further include a flexible printed circuit board (FPCB) extending from the PCB to another PCB on which the processor or the communication circuitry is disposed. The feeding line may be disposed, within the FPCB, at a second portion different from a first portion between the first conductive line and the second conductive line.

For example, the PCB may include another surface connected to the surface of the PCB where the conductive pattern is formed and is directed to the first surface. The processor may be disposed on the other surface of the PCB.

For example, the PCB may be a first PCB. The electronic device may further include a second PCB disposed on a surface directing the first surface and including a communication processor different from the processor. The electronic device may further include a third PCB including an amplifier included in the communication circuitry and connected to the conductive pattern. The conductive pattern may transmit an electric signal matched to the received wireless signal to the amplifier of the third PCB, in response to receiving a wireless signal.

According to an embodiment, an electronic device (e.g., the electronic device 101 of FIGS. 1 to 2) may include a first housing (e.g., the first housing 310-1 of FIGS. 4A to 4C). The electronic device may include a second housing (e.g., the first housing 310-2 of FIGS. 4A to 4C), which is movably coupled to the first housing, and includes a first surface, a second surface facing away from the first surface, and a third surface disposed between the first surface and the second surface, wherein a mic-hole is formed on the third surface. The electronic device may include a display (e.g., the display 280 of FIGS. 2 and/or 4A to 4C), which includes a displaying area (e.g., the displaying area 330 of FIGS. 4A to 4C) extending from the first surface of the second housing to a surface of the first housing, and insertable into the second housing or extractable from the second housing. The electronic device may include a printed circuit board (PCB) (e.g., the PCB 230 of FIG. 2). The PCB may include a conductive pattern (e.g., the conductive pattern 510 of FIGS. 5A to 5G and/or FIGS. 7A to 7E) formed on a surface of the PCB directed toward the third surface and at least partially forming an antenna structure. The PCB may be disposed adjacent to the third surface. The surface of the PCB on which the conductive pattern is formed may be disposed between a first edge between the third surface and the first surface, and a second edge of the displaying area parallel to the first edge.

For example, the electronic device may further include another PCB (e.g., the PCB 340 of FIGS. 3B to 3C and/or 4B to 4C) directed toward the first surface and disposed in the second housing. The electronic device may further include an impedance matching circuit (e.g., the impedance matching circuit 240 of FIG. 2) disposed on the other PCB, connected to a conductive line connected to the conductive pattern, and performing impedance matching of the antenna structure.

For example, the conductive pattern may include a first protruding portion including a feeding point coupled to the conductive line, and a second protruding portion faced away from the first protruding portion.

For example, the electronic device may further include another conductive line including an end connected to a grounding point included in the second protruding portion and another end that is grounded.

For example, the conductive pattern may form a slit antenna for transmitting or receiving a wireless signal using a slit formed between the first protruding portion and the second protruding portion.

For example, the conductive pattern may extend from an end of the conductive pattern, which is a feeding point connected to the conductive line, along one or more edges of the surface of the PCB.

For example, the surface of the PCB may include a first edge, a second edge parallel to the first edge, a third edge extending from an end of the first edge to an end of the second edge, and a fourth edge extending from another end of the first edge to another end of the second edge and parallel to the third edge. The conductive pattern may be a first conductive pattern extending along a first portion including an end of the first edge, a third edge, and a second portion including an end of the second edge.

For example, the PCB may further include a second conductive pattern (e.g., the conductive pattern 550 of FIG. 5D) formed on the surface of the PCB, and extending along a third portion of the first edge different from the first portion and including another end of the first edge, the fourth edge, and a fourth portion different from the second portion and including another end of the second edge. An end of the second conductive pattern included in the third portion may be grounded.

For example, the conductive line may be a first conductive line. The electronic device may further include a second conductive line including an end connected to a portion of the first conductive line and another end that is grounded.

For example, the electronic device may further include an inductor including an end connected to another end of the conductive pattern and another end that is grounded.

For example, the conductive pattern may be a first conductive pattern. The electronic device may further include a second conductive pattern, disposed perpendicular to the third surface on an edge of the third surface and at least partially forms the antenna structure by including a feeding point.

For example, the first conductive pattern may include a grounding point connected to a ground node provided from another PCB facing the first surface.

For example, the first conductive pattern may include a protruding portion protruding from the surface of the PCB toward the third surface. The protruding portion of the first conductive pattern may include a surface parallel to the second conductive pattern to increase a coupling area formed with the second conductive pattern.

For example, the PCB may further include a microphone disposed on the surface of the PCB and configured to receive an acoustic signal.

For example, the electronic device may further include a processor. The electronic device may further include an inductor including a conductive wire connecting the processor and the microphone, an end connected to the conductive wire, and another end that is grounded.

For example, the PCB may be the first PCB. For example, the electronic device may further include a second PCB including a communication processor disposed on a surface facing the first surface. The electronic device may further include a third PCB including an amplifier connected to the communication processor and the conductive pattern. In response to receiving a wireless signal, the conductive pattern may transmit an electric signal matched to the received wireless signal to the amplifier of the third PCB.

According to an embodiment, an electronic device (e.g., the electronic device 101 of FIGS. 1 to 2) may include a communication processor (e.g., the communication processor 270 of FIG. 2). The electronic device may include a housing (e.g., the housing 310 of FIGS. 3A to 3C and/or 4A to 4C) including a first surface, a second surface faced away from the first surface, and a third surface disposed between the first surface and the second surface. The electronic device may include a display (e.g., the display 280 of FIG. 2) disposed on the first surface of the housing. The electronic device may include a printed circuit board (PCB) (e.g., the PCB 230 of FIG. 2). The PCB of the electronic device may include a conductive pattern (e.g., the conductive pattern 510 of FIGS. 5A to 5G and/or FIGS. 7A to 7E) that is coupling with a conductive portion in the housing, which is coupled to a feeding line extending from the communication circuit, and formed on a surface of the PCB directed toward the third surface. The PCB may be disposed adjacent to the third surface. The surface of the PCB on which the conductive pattern is formed may be disposed between an edge between the third surface and the first surface, and an edge of a displaying area (e.g., the displaying area 330 of FIGS. 3A to 3C and/or 4A to 4C) on the first surface exposed outside.

For example, the conductive pattern may be disposed to be spaced apart from the conductive part to perform a parasitic resonance between the conductive portion and the conductive pattern while the conductive portion is activated through the feeding line.

For example, the conductive portion may be a metal frame disposed at a boundary of the third surface of the housing and perpendicular to the third surface. The conductive pattern may include a protruding portion including a surface parallel to the metal frame, by protruding toward the third surface.

For example, the display may include an area insertable into the housing. The PCB may be disposed between the area and the third surface in a state in which the area of the display is inserted into the housing.

For example, the electronic device may further include another PCB facing the first surface. The electronic device may further include an impedance matching circuit disposed on the other PCB, connected to a conductive line connected to the conductive pattern, and performing impedance matching of the antenna structure.

For example, the conductive pattern may include a grounding point connected to another end of the conductive line including an end that is grounded.

For example, the first conductive pattern may include a protruding portion protruding from the surface of the PCB toward the third surface. The protruding portion of the first conductive pattern may include a surface parallel to the second conductive pattern to increase a coupling area formed with the second conductive pattern.

For example, the electronic component may further include a microphone disposed toward a mic-hole on the surface of the PCB and configured to receive an acoustic signal.

For example, it may further include a conductive wire connecting the processor and the microphone. The electronic device may further include an inductor including an end connected to the conductive wire and another end that is grounded.

For example, the PCB may include another surface connected to the surface of the PCB on which the conductive pattern is formed and facing the first surface. The communication circuitry may be disposed on the other surface of the PCB.

For example, the PCB may be a first PCB. The electronic device may further include a second PCB including a communication processor disposed on a surface facing the first surface. The communication circuitry of the electronic device may further include a third PCB including the communication processor and an amplifier connected to the conductive pattern. The conductive pattern of the electronic device may transmit, in response to receiving a wireless signal, an electric signal matched to the received wireless signal to the amplifier of the third PCB.

The device described above may be implemented as a hardware component, a software component, and/or a combination of a hardware component and a software component. For example, the devices and components described in the embodiments may be implemented by using one or more general purpose computers or special purpose computers, such as a processor, controller, arithmetic logic unit (ALU), digital signal processor, microcomputer, field programmable gate array (FPGA), programmable logic unit (PLU), microprocessor, or any other device capable of executing and responding to instructions. The processing device may perform an operating system (OS) and one or more software applications executed on the operating system. In addition, the processing device may access, store, manipulate, process, and generate data in response to the execution of the software. For convenience of understanding, there is a case that one processing device is described as being used, but a person who has ordinary knowledge in the relevant technical field may see that the processing device may include a plurality of processing elements and/or a plurality of types of processing elements. For example, the processing device may include a plurality of processors or one processor and one controller. In addition, another processing configuration, such as a parallel processor, is also possible.

The software may include a computer program, code, instruction, or a combination of one or more thereof, and may configure the processing device to operate as desired or may command the processing device independently or collectively. The software and/or data may be embodied in any type of machine, component, physical device, computer storage medium, or device, to be interpreted by the processing device or to provide commands or data to the processing device. The software may be distributed on network-connected computer systems and stored or executed in a distributed manner. The software and data may be stored in one or more computer-readable recording medium.

The method according to the embodiment may be implemented in the form of a program command that may be performed through various computer means and recorded on a computer-readable medium. In this case, the medium may continuously store a program executable by the computer or may temporarily store the program for execution or download. In addition, the medium may be various recording means or storage means in the form of a single or a combination of several hardware, but is not limited to a medium directly connected to a certain computer system, and may exist distributed on the network. Examples of media may include a magnetic medium such as a hard disk, floppy disk, and magnetic tape, optical recording medium such as a CD-ROM and DVD, magneto-optical medium, such as a floptical disk, and those configured to store program instructions, including ROM, RAM, flash memory, and the like. In addition, examples of other media may include recording media or storage media managed by app stores that distribute applications, sites that supply or distribute various software, servers, and the like.

As described above, although the embodiments have been described with limited examples and drawings, a person who has ordinary knowledge in the relevant technical field is capable of various modifications and transform from the above description. For example, even if the described technologies are performed in a different order from the described method, and/or the components of the described system, structure, device, circuit, and the like are coupled or combined in a different form from the described method, or replaced or substituted by other components or equivalents, appropriate a result may be achieved.

Therefore, other implementations and other embodiments of the claims are in the scope of the claims described later.

## Claims

1. An electronic device (101), comprising:
a housing (310) including a first surface, a second surface opposite to the first surface, and a third surface disposed between the first surface and the second surface;
a display (280, 1030) disposed on the first surface of the housing;
a processor (120) to display an image on the display;
communication circuitry (205) connected to the processor; and
a printed circuit board, PCB, (230) having a surface directed toward the third surface of the housing; and
an electronic component (210) disposed on the surface of the PCB directed toward the third surface and connected to the processor through one or more conductive lines,
wherein the PCB includes a conductive pattern formed on the surface of the PCB directed toward the third surface in an area different from an area where the electronic component is disposed and connected to the communication circuitry through a feeding line different from the one or more conductive lines.

2. The electronic device (101) of claim 1, further comprising:
an inner housing (310-1) coupled to the housing (310-2) and movable in a first direction or a second direction opposite to the first direction,
wherein the display (280, 1030) includes a planar portion disposed on the inner housing and a deformable portion insertable into the housing, and
wherein the PCB (230) is positioned, in a state in which the deformable portion of the display is inserted into the housing, between the deformable portion and the third surface of the housing.

3. The electronic device (101) of any one of claim 1 to claim 2, wherein the conductive pattern includes:
a first protruding portion (511) including a feeding point (550) connected to the feeding line; and
a second protruding portion (512) facing away from the first protruding portion.

4. The electronic device (101) of claim 3, further comprising:
a ground line including an end connected to a grounding point included in the second protruding portion (512), and another end that is grounded.

5. The electronic device (101) of any one of claim 3 to claim 4, wherein the conductive pattern forms a slit antenna to transmit or receive a wireless signal using a slit (515) formed between the first protruding portion (511) and the second protruding portion (512).

6. The electronic device (101) of any one of claim 1 to claim 5, wherein the conductive pattern extends from an end of the conductive pattern which is a feeding point (550) coupled to the feeding line extending from the communication circuitry (205), along one or more edges of the surface of the PCB (230).

7. The electronic device (101) of any one of claim 1 to claim 6, wherein the surface of the PCB (230) comprises a first edge (230a), a second edge (230b) parallel to the first edge, a third edge (230c) extending from an end of the first edge to an end of the second edge, and a fourth edge (230d) extending from another end of the first edge to another end of the second edge and parallel to the third edge, and
wherein the conductive pattern (510) is a first conductive pattern extending along a first portion including the end of the first edge, the third edge, and a second portion including the end of the second edge.

8. The electronic device (101) of any one of claim 1 to claim 7, wherein the PCB (230) further comprises:
a second conductive pattern (550) formed on the surface of the PCB, and extending along a third portion of the first edge different from the first portion and including the another end of the first edge, the fourth edge, and a fourth portion different from the second portion and including the another end of the second edge, and
wherein an end of the second conductive pattern included in the third portion is grounded.

9. The electronic device (101) of any one of claim 1 to claim 8, wherein the housing (310) has a mic-hole formed at the third surface of the housing, and
wherein the electronic component (210) comprises a microphone configured to receive an acoustic signal and disposed toward the mic-hole.

10. The electronic device (101) of claim 9, wherein the one or more conductive lines include a first conductive line (521) configured to transmit an electric signal transmitted from an anode of the microphone to the processor (120) and a second conductive line (522) connected to a cathode of the microphone, and
wherein the first conductive line is connected to a first inductor connected to a ground and the second conductive line is connected to a second inductor connected to ground.

11. The electronic device (101) of any one of claim 1 to claim10, further comprises:
a flexible PCB (FPCB) extending from the PCB (230) to another PCB where the processor (120), or the communication circuitry (205) is disposed; and
wherein the feeding line is disposed, within the FPCB, at a second portion different from a first portion where the one or more conductive lines are disposed.

12. The electronic device (101) of any one of claim 1 to claim 11, wherein the PCB (230) includes another surface connected to the surface of the PCB and directed to the first surface of the housing (310); and
wherein the processor (120) is disposed on the another surface of the PCB.

13. The electronic device (101) of any one of claim 1 to claim 12, wherein the PCB (230) is a first PCB,
and
wherein the electronic device further comprises:
a second PCB including a communication processor that is different from the processor (120) and disposed on a surface directed toward the first surface; and
a third PCB including an amplifier connected to the conductive pattern and included in the communication circuitry (205), and
wherein the conductive pattern transmits, in response to receiving a wireless signal, an electric signal matched to the received wireless signal to the amplifier of the third PCB.

## Patentansprüche

1. Elektronische Vorrichtung (101), umfassend:
ein Gehäuse (310), das eine erste Oberfläche, eine zweite Oberfläche gegenüber der ersten Oberfläche und eine dritte Oberfläche, die zwischen der ersten Oberfläche und der zweiten Oberfläche angeordnet ist, beinhaltet;
eine Anzeige (280, 1030), die auf der ersten Oberfläche des Gehäuses angeordnet ist;
einen Prozessor (120), um ein Bild auf der Anzeige anzuzeigen;
Kommunikationsschaltung (205), die mit dem Prozessor verbunden ist; und
eine Leiterplatte, PCB, (230), die eine Oberfläche aufweist, die zu der dritten Oberfläche des Gehäuses gerichtet ist; und
eine elektronische Komponente (210), die auf der Oberfläche der PCB angeordnet ist, die zu der dritten Oberfläche gerichtet ist, und mit dem Prozessor durch eine oder mehrere leitende Leitungen verbunden ist,
wobei die PCB ein leitendes Muster beinhaltet, das auf der Oberfläche der PCB, die zu der dritten Oberfläche gerichtet ist, in einem Bereich gebildet ist, der sich von einem Bereich unterscheidet, in dem die elektronische Komponente angeordnet ist, und mit der Kommunikationsschaltung durch eine Speiseleitung verbunden ist, die sich von der einen oder den mehreren leitenden Leitungen unterscheidet.

2. Elektronische Vorrichtung (101) nach Anspruch 1, ferner umfassend:
ein Innengehäuse (310-1), das an das Gehäuse (310-2) gekoppelt und in einer ersten Richtung oder einer zweiten Richtung gegenüber der ersten Richtung bewegbar ist,
wobei die Anzeige (280, 1030) einen ebenen Abschnitt, der an dem Innengehäuse angeordnet ist, und einen verformbaren Abschnitt, der in das Gehäuse einsetzbar ist, beinhaltet, und
wobei die PCB (230) in einem Zustand, in dem der verformbare Abschnitt der Anzeige in das Gehäuse eingesetzt ist, zwischen dem verformbaren Abschnitt und der dritten Oberfläche des Gehäuses positioniert ist.

3. Elektronische Vorrichtung (101) nach einem von Anspruch 1 bis Anspruch 2, wobei das leitende Muster Folgendes beinhaltet:
einen ersten vorstehenden Abschnitt (511), der einen Speisepunkt (550), der mit der Speiseleitung verbunden ist, beinhaltet, und
einen zweiten vorstehenden Abschnitt (512), der von dem ersten vorstehenden Abschnitt abgewandt ist.

4. Elektronische Vorrichtung (101) nach Anspruch 3, ferner umfassend:
eine Erdungsleitung, die ein Ende, das mit einem Erdungspunkt verbunden ist, der in dem zweiten vorstehenden Abschnitt (512) beinhaltet ist, und ein anderes Ende, das geerdet ist, beinhaltet.

5. Elektronische Vorrichtung (101) nach einem von Anspruch 3 bis Anspruch 4, wobei das leitende Muster eine Schlitzantenne bildet, um ein drahtloses Signal unter Verwendung eines Schlitzes (515), der zwischen dem ersten vorstehenden Abschnitt (511) und dem zweiten vorstehenden Abschnitt (512) gebildet ist, zu übertragen oder zu empfangen.

6. Elektronische Vorrichtung (101) nach einem von Anspruch 1 bis Anspruch 5, wobei sich das leitende Muster von einem Ende des leitenden Musters, das ein Speisepunkt (550) ist, der an die Speiseleitung gekoppelt ist, die sich von der Kommunikationsschaltung (205) erstreckt, entlang einer oder mehrerer Kanten der Oberfläche der PCB (230) erstreckt.

7. Elektronische Vorrichtung (101) nach einem von Anspruch 1 bis Anspruch 6, wobei die Oberfläche der PCB (230) eine erste Kante (230a), eine zweite Kante (230b) parallel zu der ersten Kante, eine dritte Kante (230c), die sich von einem Ende der ersten Kante zu einem Ende der zweiten Kante erstreckt, und eine vierte Kante (230d), die sich von einem anderen Ende der ersten Kante zu einem anderen Ende der zweiten Kante und parallel zu der dritten Kante erstreckt, umfasst, und
wobei das leitende Muster (510) ein erstes leitendes Muster ist, das sich entlang eines ersten Abschnittes, der das Ende der ersten Kante, die dritte Kante und einen zweiten Abschnitt, der das Ende der zweiten Kante beinhaltet, erstreckt.

8. Elektronische Vorrichtung (101) nach einem von Anspruch 1 bis Anspruch 7, wobei die PCB (230) ferner Folgendes umfasst:
ein zweites leitendes Muster (550), das auf der Oberfläche der PCB gebildet ist und sich entlang eines dritten Abschnittes der ersten Kante erstreckt, der sich von dem ersten Abschnitt unterscheidet und das andere Ende der ersten Kante, die vierte Kante und einen vierten Abschnitt, der sich von dem zweiten Abschnitt unterscheidet und das andere Ende der zweiten Kante beinhaltet, beinhaltet, und
wobei ein Ende des zweiten leitenden Musters, das in dem dritten Abschnitt beinhaltet ist, geerdet ist.

9. Elektronische Vorrichtung (101) nach einem von Anspruch 1 bis Anspruch 8, wobei das Gehäuse (310) ein Mikroloch aufweist, das auf der dritten Oberfläche des Gehäuses gebildet ist, und
wobei die elektronische Komponente (210) ein Mikrofon umfasst, das dazu konfiguriert ist, ein akustisches Signal zu empfangen, und zu dem Mikroloch angeordnet ist.

10. Elektronische Vorrichtung (101) nach Anspruch 9, wobei die eine oder mehreren leitenden Leitungen eine erste leitende Leitung (521), die dazu konfiguriert ist, ein elektrisches Signal, das von einer Anode des Mikrofons an den Prozessor (120) übertragen wird, zu übertragen, und eine zweite leitende Leitung (522), die mit einer Kathode des Mikrofons verbunden ist, beinhalten, und
wobei die erste leitende Leitung mit einem ersten Induktor verbunden ist, der mit einer Erdung verbunden ist, und die zweite leitende Leitung mit einem zweiten Induktor verbunden ist, der mit Erdung verbunden ist.

11. Elektronische Vorrichtung (101) nach einem von Anspruch 1 bis Anspruch 10, umfasst ferner:
eine flexible PCB (FPCB), die sich von der PCB (230) zu einer anderen PCB erstreckt, wo der Prozessor (120) oder die Kommunikationsschaltung (205) angeordnet ist; und
wobei die Speiseleitung innerhalb der FPCB an einem zweiten Abschnitt angeordnet ist, der sich von einem ersten Abschnitt unterscheidet, in dem die eine oder mehreren leitenden Leitungen angeordnet sind.

12. Elektronische Vorrichtung (101) nach einem von Anspruch 1 bis Anspruch 11, wobei die PCB (230) eine andere Oberfläche beinhaltet, die mit der Oberfläche der PCB verbunden und zu der ersten Oberfläche des Gehäuses (310) gerichtet ist; und
wobei der Prozessor (120) auf der anderen Oberfläche der PCB angeordnet ist.

13. Elektronische Vorrichtung (101) nach einem von Anspruch 1 bis Anspruch 12, wobei die PCB (230) eine erste PCB ist, und
wobei die elektronische Vorrichtung ferner Folgendes umfasst:
eine zweite PCB, die einen Kommunikationsprozessor beinhaltet, der sich von dem Prozessor (120) unterscheidet und auf einer Oberfläche angeordnet ist, die zu der ersten Oberfläche gerichtet ist; und
eine dritte PCB, die einen Verstärker beinhaltet, der mit dem leitenden Muster verbunden und in der Kommunikationsschaltung (205) enthalten ist, und
wobei das leitende Muster als Reaktion auf das Empfangen eines drahtlosen Signals ein elektrisches Signal, das an das empfangene drahtlose Signal angepasst ist, an den Verstärker der dritten PCB überträgt.

## Revendications

1. Dispositif électronique (101), comprenant :
un boîtier (310) comprenant une première surface, une deuxième surface opposée à la première surface, et une troisième surface disposée entre la première surface et la deuxième surface ;
un affichage (280, 1030) disposé sur la première surface du boîtier ;
un processeur (120) pour afficher une image sur l'affichage ;
un circuit de communication (205) connecté au processeur ; et
une carte de circuit imprimé, PCB, (230) ayant une surface dirigée vers la troisième surface du boîtier ; et
un composant électronique (210) disposé sur la surface de la PCB dirigée vers la troisième surface et connecté au processeur via une ou plusieurs lignes conductrices, dans lequel la PCB comprend un motif conducteur formé sur la surface de la PCB dirigée vers la troisième surface dans une zone différente d'une zone où le composant électronique est disposé et connecté au circuit de communication via une ligne d'alimentation différente de l'une ou plusieurs lignes conductrices.

2. Dispositif électronique (101) selon la revendication 1, comprenant en outre :
un boîtier interne (310-1) couplé au boîtier (310-2) et mobile dans une première direction ou une seconde direction opposée à la première direction, dans lequel l'affichage (280, 1030) comprend une partie plane disposée sur le boîtier interne et une partie déformable insérable dans le boîtier,
et
dans lequel la PCB (230) est positionnée, dans un état dans lequel la partie déformable de l'affichage est insérée dans le boîtier, entre la partie déformable et la troisième surface du boîtier.

3. Dispositif électronique (101) selon l'une quelconque de la revendication 1 à la revendication 2, dans lequel le motif conducteur comprend :
une première partie saillante (511) comprenant un point d'alimentation (550) connecté à la ligne d'alimentation ; et une deuxième partie saillante (512) tournée à l'opposé de la première partie saillante.

4. Dispositif électronique (101) selon la revendication 3, comprenant en outre :
une ligne de mise à la terre comprenant une extrémité connectée à un point de mise à la terre compris dans la deuxième partie saillante (512), et une autre extrémité qui est mise à la terre.

5. Dispositif électronique (101) selon l'une quelconque de la revendication 3 à la revendication 4, dans lequel le motif conducteur forme une antenne à fente pour émettre ou recevoir un signal sans fil à l'aide d'une fente (515) formée entre la première partie saillante (511) et la deuxième partie saillante (512).

6. Dispositif électronique (101) selon l'une quelconque de la revendication 1 à la revendication 5, dans lequel le motif conducteur s'étend à partir d'une extrémité du motif conducteur qui est un point d'alimentation (550) couplé à la ligne d'alimentation s'étendant à partir du circuit de communication (205), le long d'un ou de plusieurs bords de la surface de la PCB (230).

7. Dispositif électronique (101) selon l'une quelconque de la revendication 1 à la revendication 6, dans lequel la surface de la PCB (230) comprend un premier bord (230a), un deuxième bord (230b) parallèle au premier bord, un troisième bord (230c) s'étendant d'une extrémité du premier bord à une extrémité du deuxième bord, et un quatrième bord (230d) s'étendant d'une autre extrémité du premier bord à une autre extrémité du deuxième bord et parallèle au troisième bord, et
dans lequel le motif conducteur (510) est un premier motif conducteur s'étendant le long d'une première partie comprenant l'extrémité du premier bord, le troisième bord, et une deuxième partie comprenant l'extrémité du deuxième bord.

8. Dispositif électronique (101) selon l'une quelconque de la revendication 1 à la revendication 7, dans lequel la PCB (230) comprend en outre :
un second motif conducteur (550) formé sur la surface de la PCB, et s'étendant le long d'une troisième partie du premier bord différente de la première partie et comprenant l'autre extrémité du premier bord, le quatrième bord, et une quatrième partie différente de la deuxième partie et comprenant l'autre extrémité du deuxième bord, et dans lequel une extrémité du second motif conducteur compris dans la troisième partie est mise à la terre.

9. Dispositif électronique (101) selon l'une quelconque de la revendication 1 à la revendication 8, dans lequel le boîtier (310) a un micro-trou formé au niveau de la troisième surface du boîtier, et dans lequel le composant électronique (210) comprend un microphone configuré pour recevoir un signal acoustique et disposé vers le micro-trou.

10. Dispositif électronique (101) selon la revendication 9, dans lequel l'une ou plusieurs lignes conductrices comprennent une première ligne conductrice (521) configurée pour transmettre un signal électrique transmis d'une anode du microphone au processeur (120) et une seconde ligne conductrice (522) connectée à une cathode du microphone, et
dans lequel la première ligne conductrice est connectée à une première inductance connectée à une masse et la seconde ligne conductrice est connectée à une seconde inductance connectée à la masse.

11. Dispositif électronique (101) selon l'une quelconque de la revendication 1 à la revendication 10, comprenant en outre :
une PCB souple (FPCB) s'étendant à partir de la PCB (230) vers une autre PCB où le processeur (120), ou le circuit de communication (205) est disposé ; et
dans lequel la ligne d'alimentation est disposée, à l'intérieur de la FPCB, au niveau d'une deuxième partie différente d'une première partie où l'une ou plusieurs lignes conductrices sont disposées.

12. Dispositif électronique (101) selon l'une quelconque de la revendication 1 à la revendication 11, dans lequel la PCB (230) comprend une autre surface connectée à la surface de la PCB et dirigée vers la première surface du boîtier (310) ; et
dans lequel le processeur (120) est disposé sur l'autre surface de la PCB.

13. Dispositif électronique (101) selon l'une quelconque de la revendication 1 à la revendication 12, dans lequel la PCB (230) est une première PCB, et dans lequel le dispositif électronique comprend en outre :
une deuxième PCB comprenant un processeur de communication qui est différent du processeur (120) et disposé sur une surface dirigée vers la première surface ; et
une troisième PCB comprenant un amplificateur connecté au motif conducteur et compris dans le circuit de communication (205), et
dans lequel le motif conducteur transmet, en réponse à la réception d'un signal sans fil, un signal électrique adapté au signal sans fil reçu à l'amplificateur de la troisième PCB.
